Europäisches Patentamt

European Patent Office

Office européen des brevets

(19)

(11) Publication number: **0 578 123 A2**

# EUROPEAN PATENT APPLICATION

(12)

(21) Application number: 93110452.5

(51) Int. Cl.5: **G01R 31/08**

(22) Date of filing: **30.06.93**

(30) Priority: **30.06.92 JP 196552/92**
**31.03.93 JP 96856/93**

(43) Date of publication of application:
**12.01.94 Bulletin 94/02**

(84) Designated Contracting States:
**CH DE FR GB LI SE**

(71) Applicant: **Kabushiki Kaisha Toshiba**
**72, Horikawa-cho**
**Saiwai-ku**

**Kawasaki-shi(JP)**

(72) Inventor: **Andow, Fumio, c/o Int. Pty. Div. K.K.**
**Toshiba**
**1-1, Shibaura 1-chome**
**Minato-ku, Tokyo 105(JP)**

(74) Representative: **Henkel, Feiler, Hänzel &**
**Partner**
**Möhlstrasse 37**
**D-81675 München (DE)**

(54) **Fault locator for a transmission line.**

(57) A fault locator includes fault point determining means for receiving a voltage and current of at least one point of a transmission line and calculating a distance XL from a specified point on the transmission line to a fault point which is at least one of short-circuiting and grounding faults occurring on the transmission line according to the relation between a fault phase voltage V in a fault section of the transmission line and the product $\Sigma IZ$ of a current I and an impedance Z expressing a voltage drop with respect to the fault phase voltage V, and the fault locator further includes first means for calculating the value of a voltage $V_F$ of the fault point, second means for calculating a value of the product $\Sigma IZ$ of a preset current I flowing in the fault section of the transmission line and the impedance Z, and third means for calculating a value $Q_{VF} \propto V_F/\Sigma IZ$ which varies in proportion to the quotient of the value obtained by the first means divided by the value obtained by the second means as a fault point voltage hypothesis error $Q_{VF}$.

FIG. 3

EP 0 578 123 A2

This invention relates to a fault locator for determining a fault point by use of a voltage and current of a transmission line in fault and a distance relay for protecting the transmission line.

A fault locator for receiving a voltage and current of a transmission line terminal and calculating a distance from a specified point of the transmission line to the fault point of a short or earth fault occurring in the transmission line has been used in the prior art.

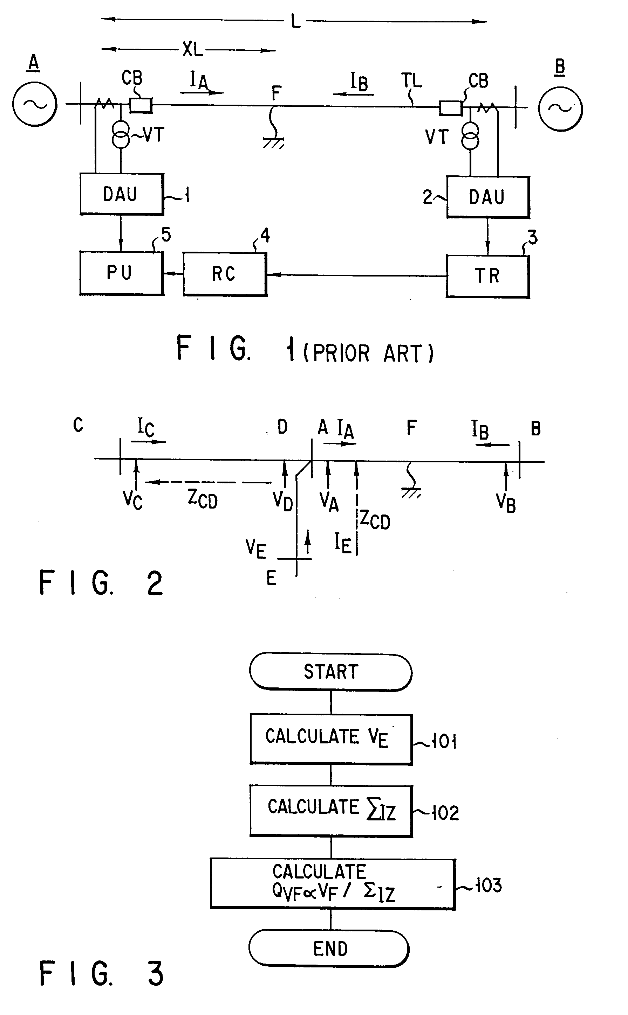

Most of the conventional fault locators are of distance relay type and the distance measuring principle thereof is explained with reference to Fig. 1. Fig. 1 is a diagram showing the construction of the conventional fault locator used in a 2-terminal transmission line. The construction of the fault locator of this invention is the same as that shown in Fig. 1 as will be described later.

In Fig. 1, TL denotes a transmission line, A and B denote terminals of the transmission line TL, CB denotes a circuit breaker, CT denotes a current transformer, VT denotes a voltage transformer, and F denotes a fault point. The fault locator includes data acquiring units 1 and 2, transmitting unit (TR) 3, receiving unit (RC) 4, and processing unit (PU) 5. The length of the transmission line between the terminals A and B is L (the unit of length is kilometer, for example) and the fault point F lies at a distance of XL from the terminal A. The data acquiring units 1 and 2 acquire currents $I_A$ and $I_B$ and voltages $V_A$ and $V_B$ of respective phases of the terminals from the voltage transformers VT and current transformers CT of the respective terminals A and B. Data from the data acquiring unit 2 is supplied to the processing unit 5 via the transmitting unit 3 and receiving unit 4 and data from the data acquiring unit 1 is directly supplied to the processing unit 5. The processing unit 5 calculates a distance XL from the terminal A to the fault point F or a distance (1-X)L from the terminal B to the fault point F by use of the received data. In most of the single side determination type apparatuses which will be described later, data of the terminal B is not used, and in this case, the apparatus can be constructed only by the data acquiring unit 1 and processing unit 5.

In order to generalize the explanation for the processing, the terminals A and B are treated as specified points A and B on a fault section of the transmission line in the following explanation.

The single side determination type apparatus is disclosed in Examined Japanese Patent Publication No. 58-29471, for example, uses a voltage drop between the fault point F and the specified point A lying on one side of the fault point on the transmission line of the fault section and calculates a distance from the point A to the fault point based on the ratio of the voltage drop to the product of a current flowing from the point A to the fault point.

In general, the single side determination type apparatus uses the equation (1) with the fault phase set as an object to calculate a distance from the transmission line terminal to the fault point (refer to the equation (20) in the above-described Japanese Patent Publication). In this case, Im[xx] indicates an imaginary part of xx, $I_A$ and $V_A$ respectively denote a current at the point A and a fault phase voltage, and the direction of $I_A$ is indicated by an arrow in Fig. 1. $I_{EF}$ is an equivalent current of the current $I_F$ in the fault point, and in a case where data of the point B can be used, the sum of currents $I_A$ and $I_B$ of the fault phase is used, but in other cases, a difference between a value of the current $I_A$ of the fault phase before and after the fault is often used. $I_{FE}^*$ denotes a conjugate complex number of $I_{FE}$ and Z indicates an impedance of the transmission line representing a voltage drop with respect to the fault phase voltage. $\Sigma I_A Z$ indicates the sum of the products of currents of the respective phases and self- or mutual impedances of the relative fault phases, and in the following description, the sum of the products of the impedances and the currents expressed by, for example, the equation (2) (in which the fault phase is an a phase) is indicated in the form of $\Sigma IZ$ and is referred to as "product $\Sigma IZ$" for simple expression. Further, $\overline{Ia}$, $Ib$, $Ic$ indicate currents of a, b, c phases, Zaa, Zab, Zac indicate self- and mutual impedances between the $\underline{a}$ phase and the a, b, c phases, and similar symbols are used to indicate similar impedances.

The both side comparison type apparatus is disclosed in Examined Japanese Patent Publication No. 57-50262 and uses a voltage difference between specified points A and B lying on both sides of the fault point on the transmission line of the fault section and the product using currents flowing from the points A and B towards the fault point to calculate a distance from the point A or B to the fault point.

In general, the both side comparison type apparatus uses the equation (3) to calculate a distance with the fault phase set as an object. In this case, $V_B$ and $I_B$ indicate a voltage and current at the point B and the direction of $I_B$ is indicated by an arrow in Fig. 1.

$$XL = Im[V_A \times I_{FE}^*]/Im[\Sigma I_A Z \times I_{FE}^*] \quad (1)$$

$$\Sigma = IaZaa + IbZab + IcZac \quad (2)$$

$$XL = (V_A - V_B + L\Sigma I_B Z)/\Sigma(I_A + I_B)Z \quad (3)$$

2

In a multiple terminal transmission line, the conventional fault point determination procedure effected in a case where data of voltages and currents in the respective terminals is explained by using a 3-terminal transmission line as an example with reference to Fig. 2. In Fig. 2, data of voltages and currents in terminals B, C and E is acquired. In this case, a sound section is determined prior to the fault point determination. For this purpose, voltages $V_{DB}$, $V_{DC}$ and $V_{DE}$ between the branch point D and the respective terminals B, C and D are calculated by use of voltage and current data in the respective terminals according to the following equations (3a) to (3c).

$$V_{DB} = V_B - \Sigma I_B Z_{BD} \qquad (3a)$$

$$V_{DC} = V_C - \Sigma I_C Z_{CD} \qquad (3b)$$

$$V_{DE} = V_E - \Sigma I_E Z_{ED} \qquad (3c)$$

In the above equations, $\Sigma I_B Z_{BD}$, $\Sigma I_C Z_{CD}$, $\Sigma I_E Z_{ED}$ indicates the products of the currents $I_B$, $I_C$ and $I_E$ and the impedances $Z_{BD}$, $Z_{CD}$ and $Z_{ED}$ indicating the voltage drops for the fault phase between the branch point D and the respective terminals. If no fault occurs in the transmission line of Fig. 2, the calculated values obtained in the respective equations are equal to each other when small differences are neglected. When a fault occurs between the terminals B and D as shown in Fig. 2, $V_{DC}$ and $V_{DE}$ are equal to each other and paths between the terminals C and D and E and D are determined as a sound section. At this time, $V_{DB}$ takes a different value and the path between the terminals B and D is determined not to be a sound section. Based on the above determination, the value of the voltage $V_A$ is determined as one of the branch point voltages $V_{DC}$ and $V_{DE}$ calculated by use of data of the terminals of the sound section according to the equations (1) or (3), the value of the current $I_A$ is determined as the sum of $I_C$ and $I_E$ to calculate a distance XL.

Conventionally, in the above fault locators, although it can be predicted that a large error may occur in the determined distance depending on the condition of fault, a value (which is hereinafter referred to as a hypothesis error) indicating a range in which values of errors are hypothesized to be set is not calculated. It is extremely effective in the application of the fault locator to know the value of the hypothesis error. For example, in a case where a fault point is searched by inspection, the way of inspection is changed according to the magnitude of hypothesis error so that the inspection can be made intensively for a region in which the probability of occurrence of fault is high. The hypothesis errors in the calculated distances by the fault locators are not so simple as to vary in proportion to only the calculated distance XL, some components which do not at all vary in proportion to XL are contained therein, and the component which does not vary in proportion to XL may sometimes occupy a large portion according to the condition of fault. However, conventionally, means for hypothesizing the value of the error is not provided and substantially the same procedure must be taken on the assumption that the same error may occur irrespective of the magnitude of the non-proportional component.

Further, in the distance relay apparatus and fault locator of multiple terminal transmission line, no special consideration is given to the selection of one of values calculated by a plurality of calculating means when a voltage of the branch point is calculated.

An object of this invention is to newly provide effective calculating means for hypothesis error of a fault locator.

Another object of this invention is to newly provide calculating means for calculating the voltage of a branch point in which the probability of occurrence of error is minimum.

The first fault locator of this invention is characterized by including fault point determining means for receiving a voltage and current of at least one point of a transmission line and calculating a distance XL from a specified point on the transmission line to a fault point which is at least one of short-circuiting and grounding faults occurring on the transmission line according to the relation between a fault phase voltage V in a fault section of the transmission line and the product $\Sigma IZ$ of a current I and an impedance Z expressing a voltage drop for the fault phase voltage V, comprising:

first means for calculating the value of a voltage $V_F$ of the fault point by use of the fault phase voltage V, the product $\Sigma_{IZ}$ and the distance XL;

second means for calculating a value of the product $\Sigma IZ$ of a preset current I flowing in the fault section of the transmission line and the impedance Z; and

third means for calculating a value $Q_{VF} \propto V_F/\Sigma IZ$ which varies in proportion to the quotient of the value obtained by the first means divided by the value which is obtained by the second means as a fault point voltage hypothesis error $Q_{VF}$.

3

Further, it is characterized in that the fault point determining means is formed of single side determination type for measuring a distance by use of a voltage drop between a fault point F and a specified point A lying on one of two sides of the fault point on the fault section of the transmission line, and the preset current I is given by a current $I_A$ flowing in a direction from the specified point A side to the fault point; and characterized in that the fault point determining means is formed of both side comparison type for measuring a distance by use of a voltage difference between specified points A and B lying on both sides of the fault point on the fault section of the transmission line, and the preset current I is given by a current $(I_A + I_B)$ which is the sum of currents $I_A$ and $I_B$ flowing from both of the specified points A and B towards the fault point.

The second fault locator of this invention is characterized by including both side comparison type fault point determining means for receiving voltages and currents of a plurality of points of a transmission line and calculating a distance XL from a specified point A to a fault point which is at least one of short-circuiting and grounding faults occurring on the transmission line according to the relation between a difference in a fault phase voltage V between the specified points A and B lying on both sides of the fault point in the fault section of the transmission line and the product $\Sigma IZ$ of a current I and an impedance Z expressing a voltage drop for the fault phase voltage V, comprising:

means for calculating a first term which is a function of a quotient of at least one of the term of the product $\Sigma I_A Z$ using the calculated value XL of the distance from the point A and a current $I_A$ flowing from the point A towards the fault point and the term of the sum $\Sigma |I_A Z|$ of the magnitudes of respective terms constructing the $\Sigma I_A Z$ divided by the term of the product $\Sigma(I_A + I_B)Z$ using the sum of the currents $I_A$ and $I_B$;

means for calculating a second term which is a function of a quotient of at least one of the term of the product $\Sigma I_B Z$ using the calculated value (1-X)L of the distance from the point B and a current $I_B$ flowing from the point B towards the fault point and the term of the sum $\Sigma |I_B Z|$ of magnitudes of respective terms constructing the $\Sigma I_B Z$ divided by the term of the product $\Sigma(I_A + I_B)Z$; and

means for calculating a distance proportional error $Q_{XL}$ by using the sum of the first and second terms and one of the first and second terms.

Further, it is characterized in that the distance proportional error $Q_{XL}$ is given by a quotient of the sum of the magnitude of a value obtained by multiplying the product $XL\Sigma I_A Z$ by a preset constant $K_A$ and the magnitude of a value obtained by multiplying the product $(1-X)L\Sigma I_B Z$ by a preset constant $K_B$ divided by the magnitude of a value of the product $\Sigma(I_A + I_B)Z$, that is,

$$Q_{XL} = \{|K_A XL\Sigma I_A Z| + |K_B(1-X)L\Sigma I_B Z|\} /|\Sigma(I_A + I_B)Z|.$$

It is also characterized in that the distance proportional error $Q_{XL}$ is given by the following equation:

$$Q_{XL} = \{|K_A'XL\Sigma I_A Z - K_B'(1-X)L\Sigma I_B Z| + |K_A XL\Sigma I_A Z| + |K_B(1-X)L\Sigma I_B Z|\} /|\Sigma(I_A + I_B)Z|.$$

It is also characterized in that the distance proportional error $Q_{XL}$ is given by the following equation:

$$Q_{XL} = \{|K_A XL\Sigma |I_A Z| - K_B(1-X)L\Sigma |I_B Z| |\} /|(I_A + I_B)Z|.$$

It is also characterized in that the distance proportional error $Q_{XL}$ is given by the following equation:

$$Q_{XL} = \{|K_A'XL\Sigma I_A Z - K_B'(1-X)L\Sigma I_B Z| + K_A XL\Sigma |I_A Z| + |K_B(1-X)L\Sigma |I_B Z| |\} /|\Sigma(I_A + I_B)Z|.$$

It is also characterized in that the distance proportional error $Q_{XL}$ is given by the following equation:

$$Q_{XL} = [(K_A XL\Sigma I_A Z)^2 + \{K_B(1-X)L\Sigma I_B Z\}^2]^{1/2} /|\Sigma(I_A + I_B)Z|.$$

It is also characterized in that the distance proportional error $Q_{XL}$ is given by $Q_{XLA}$ and $Q_{XLB}$ expressed by the following equations:

$$Q_{XLA} = |K_A XL\Sigma I_A Z/\Sigma(I_A + I_B)Z|, \text{ and}$$
$$Q_{XLB} = |K_B(1-X)L\Sigma I_B Z/\Sigma(I_A + I_B)Z|.$$

The third fault locator of this invention is characterized by including fault point determination means which includes distance measuring means for receiving a voltage and current of at least one point of a transmission line and calculating a distance XL from a specified point on a fault section of the transmission line to a fault point which is at least one of short-circuiting and grounding faults occurring on the transmission line according to the relation between a fault phase voltage V in the fault section of the transmission line and the product $\Sigma IZ$ of a current I and an impedance Z expressing a voltage drop for the fault phase voltage V and specified-point-voltage calculating means for calculating a value of a voltage $V_D$ of a specified point D lying on the sound section of the transmission line near the fault point by use of a voltage $V_C$ of another specified point C lying on the sound section at a far distance from the fault point and the product $\Sigma I_C Z_{CD}$ of a current $I_C$ flowing from the point C towards the point D and an impedance $Z_{CD}$ betweenthe points C and D, comprising:

first means for calculating a value of one of the product $\Sigma I_C Z_{CD}$ and the sum $\Sigma |I_C Z_{CD}|$ of the magnitudes of respective terms of the product;

second means for calculating a value of the product $\Sigma IZ$ of a preset current I flowing in the fault section of the transmission line and the impedance Z; and

third means for calculating one of values $Q_{CD}$ $\Sigma I_C Z_{CD}/\Sigma IZ$ and $Q_{CD} \propto \Sigma |I_C Z_{CD}|/\Sigma IZ$ which varies in proportion to the quotient of one of the product $\Sigma I_C Z_{CD}$ and the sum $\Sigma |I_C Z_{CD}|$ obtained by the first means divided by the product $\Sigma IZ$ which is obtained by the second means as a sound section hypothesis error $Q_{VF}$.

Further, it is characterized in that the distance measuring means is formed of single side determination type for measuring a distance XL from a point A lying on one of two sides of the fault point on the fault section of the transmission line by use of a voltage drop between a fault point F and the specified point A, and the preset current I is given by a current $I_A$ flowing in a direction from the specified point A side to the fault point. In this aspect, it is characterized in that the distance measuring means includes means for calculating a distance XL from the specified point A when the point A coincides with the point D.

It is characterized in that the distance measuring means is formed of both side comparison type for measuring a distance XL from specified points A and B lying on both sides of the fault point on the fault section of the transmission line by use of a voltage difference between the specified points A and B, and the preset current I is given by a current $(I_A + I_B)$ which is the sum of currents $I_A$ and $I_B$ flowing from both of the specified points A and B towards the fault point. In this aspect, it is characterized in that the distance measuring means includes means for calculating a distance XL from the specified points A and B when one of the points A and B coincides with the point D. It is characterized in that the self-point determination means is formed of single side determination type for measuring a distance by use of a voltage drop between a fault point F and a specified point A lying on one of two sides of the fault point on the fault section of the transmission line, the preset current I is given by a current $I_A$ flowing in a direction from the specified point A side to the fault point, and a value of $Q_{XL}$ is calculated as a value which is proportional to a calculated value XL of the distance between the specified point A and the fault point. It is characterized in that the value of $Q_{XL}$ is given by a value $K_A Q_{XL}$ obtained by multiplying a calculated value XL of distance between the specified point A and the fault point by a specified constant $K_A$. It is characterized in that the value of $Q_{XL}$ is given by a value $XL\{KA'' + (K_A \Sigma |IZ|/|\Sigma IZ|)\}$ which is obtained by multiplying a calculated value XL of distance between the specified point A and the fault point by a value derived by the sum of a specified constant $K_A''$ and the quotient of the product of a specified constant $K_A$ and the sum $\Sigma |IZ|$ of the magnitudes of respective terms of the product $\Sigma IZ$ divided by the magnitude of the product $\Sigma IZ$. It is characterized in that the fault point determination means is formed of both side comparison type for measuring a distance by use of a voltage difference between specified points A and B lying on both sides of the fault point on the fault section of the transmission line, the preset current I is given by a current $(I_A + I_B)$ which is the sum of currents $I_A$ and $I_B$ flowing from both of the specified points towards the fault point, and the value of $Q_{XL}$ is given by the sum of one of the term of the product $\Sigma I_A Z$ using a calculated value XL of distance from the point A and a current $I_A$ on the point A side and the term of the sum $\Sigma |I_A Z|$ of the magnitudes of respective terms constituting $\Sigma I_A Z$ and one of the term of the product $\Sigma I_B Z$ using a calculated value (1-X)L of distance from the point B and a current $I_B$ on the point B side and the term of the sum $\Sigma |I_B Z|$ of the magnitudes of respective terms constituting $\Sigma I_B Z$.

The fourth fault locator of this invention is characterized by including fault point determination means for receiving a voltage and current of at least one point of a transmission line and calculating a distance XL from a specified point on a fault section of the transmission line to a fault point which is at least one of short-circuiting and grounding faults occurring on the transmission line according to the relation between a fault phase voltage V in the fault section of the transmission line and the product $\Sigma IZ$ of a current I and an impedance Z expressing a voltage drop for the fault phase voltage V, comprising:

first means for calculating a value of fault point voltage $V_F$;

second means for calculating a value of the product $\Sigma IZ$ of a preset current I flowing in the fault section of the transmission line and the impedance Z;

third means for calculating a value $Q_{VF} \propto V_F/\Sigma IZ$ which varies in proportion to the quotient of the value obtained by the first means divided by the value obtained by the second means as a fault point voltage hypothesis error $Q_{VF}$;

fourth means for calculating a value $Q_{XL}$ having a functional relation with the distance XL as a distance proportional error $Q_{XL}$; and

fifth means for outputting one of a first value derived by combining the value $Q_{VF}$ calculated by the third means and the value $Q_{XL}$ calculated by the fourth means and a second value calculated by using a value derived by adding the functions of the two values.

The fifth fault locator of this invention is characterized by including fault point determination means which includes distance measuring means for receiving a voltage and current of at least one point of a transmission line and calculating a distance XL from a specified point on a fault section of the transmission line to a fault point which is at least one of short-circuiting and grounding faults occurring on the transmission line according to the relation between a fault phase voltage V in the fault section of the transmission line and the product $\Sigma IZ$ of a current I and an impedance Z expressing a voltage drop for the fault phase voltage V and specified-point-voltage calculating means for calculating a value of a voltage $V_D$ of a specified point D lying on the sound section of the transmission line near the fault point by use of a voltage $V_C$ of another specified point C lying on the sound section at a far distance from the fault point and the product $\Sigma I_C Z_{CD}$ of a current $I_C$ flowing from the point C towards the point D and an impedance $Z_{CD}$ betweenthe points C and D, comprising:

first means for calculating a value of fault point voltage $V_F$;

second means for calculating a value of the product $\Sigma IZ$ of a preset current I flowing in the fault section of the transmission line and the impedance Z;

third means for calculating a value $Q_{VF} \propto V_F/\Sigma IZ$ which varies in proportion to the quotient of the value obtained by the first means divided by the value obtained by the second means as a fault point voltage hypothesis error $Q_{VF}$;

fourth means for calculating a value $Q_{XL}$ having a functional relation with the distance XL calculated by the distance measuring means as a distance proportional error $Q_{XL}$;

fifth means for calculating one of values $Q_{CD} \ \Sigma I_C Z_{CD}/\Sigma IZ$ and $Q_{CD} \propto \Sigma|I_C Z_{CD}|/\Sigma IZ$ which varies in proportion to the quotient of one of the product $\Sigma I_C Z_{CD}$ calculated by the specified-point-voltage calculating means and the sum $\Sigma|I_C Z_{CD}|$ of the magnitudes of respective terms thereof divided by the product $\Sigma IZ$ obtained by the second means as a sound section hypothesis error $Q_{CD}$; and

sixth means for outputting one of a first value derived by combining the value $Q_{VF}$ calculated by the third means, the value $Q_{XL}$ calculated by the fourth means and the value $Q_{CD}$ calculated by the first means and a second value calculated by using a value derived by adding the functions of the three values.

The sixth fault locator of this invention is characterized by comprising distance measuring means for receiving voltages and currents of a plurality of points of a multiple terminal transmission line and calculating a distance XL from a specified point on a fault section of the transmission line to a fault point which is at least one of short-circuiting and grounding faults occurring on the transmission line according to the relation between a fault phase voltage V in the fault section of the transmission line and the product $\Sigma IZ$ of a current I and an impedance Z expressing a voltage drop for the fault phase voltage V; and branch-point-voltage calculating means for calculating a value of a voltage of a branch point between a sound section and the fault section of the transmission line by subtracting a voltage drop of the sound section of the transmission line from one of voltages V1 to Vn of a plurality of points P1 to Pn which are selected from the plurality of points and have no fault point between themselves and the branch point by use of the voltages V1 to Vn, currents I1 to In and the impedance of the transmission line in the sound section;

wherein the branch-point-voltage calculating means includes means for calculating a value of the voltage of the branch point by using a voltage of one of a point which is selected from the points P1 to Pn so that the fault phase voltage drop in the sound section of the transmission line between itself and the branch point becomes minimum and a corresponding point and a voltage drop of the transmission line between the point and the branch point.

It is also characterized that the branch-point-voltage calculating means includes means for calculating a branch point voltage $V_D$ according to an operation procedure using a smaller value of the magnitudes of the fault phase voltage drops $\Sigma IZ$ in the sound section.

The seventh fault locator of this invention is characterized by comprising distance measuring means for receiving voltages and currents of a plurality of points of a multiple terminal transmission line and calculating a distance XL from a specified point on a fault section of the transmission line to a fault point which is at least one of short-circuiting and grounding faults occurring on the transmission line according to the relation between a fault phase voltage V in the fault section of the transmission line and the product $\Sigma IZ$

of a current I and an impedance Z expressing a voltage drop for the fault phase voltage V; and branch-point-voltage calculating means for calculating a value of a voltage of a branch point between a sound section and the fault section of the transmission line by subtracting a voltage drop of the sound section of the transmission line from one of voltages V1 to Vn of a plurality of points P1 to Pn which are selected from the plurality of points and have no fault point between themselves and the branch point by use of the voltages V1 to Vn, currents I1 to In and the impedance of the transmission line in the sound section;

wherein the branch-point-voltage calculating means includes means for calculating a value of the voltage of the branch point by using a voltage of one of a point of the points P1 to Pn at which the fault phase voltage is minimum and a corresponding point and a voltage drop of the transmission line between the point and the branch point.

Further, it is characterized in that the branch-point-voltage calculating means includes means for calculating a branch point voltage $V_D$ according to an operation procedure for comparing the magnitudes of voltages of the respective terminals of the sound section and using the lowest voltage.

The other constructions may be made by calculating means for calculating a plurality of different distances XL, means for calculating hypothesis errors for the respective calculating means for the plurality of different distances XL, and means for outputting distances calculated by the calculating means for the plurality of different distances XL together with the respective hypothesis errors; or a plurality of different distances XL, means for calculating hypothesis errors for the respective calculating means for the plurality of different distances XL, and means for preferentially outputting a distance XL which is calculated by the calculating means for the plurality of different distances XL and has a small hypothesis error.

According to this invention, in the fault point determination of a fault locator, hypothesis values of various errors can be derived and a great convenience can be attained in the search of a fault point.

This invention can be more fully understood from the following detailed description when taken in conjunction with the accompanying drawings, in which:

Fig. 1 is a diagram showing the construction of the conventional fault locator;

Fig. 2 is a single line diagram of a 3-terminal transmission line;

Fig. 3 is a flowchart for illustrating the first operation of the apparatus of this invention;

Fig. 4 is a vector diagram showing the relation between a voltage and current at and fault point and a specified point on the transmission line;

Fig. 5 is a vector diagram for illustrating a distance measuring error and the distance measuring principle of the single side determination type fault locator;

Fig. 6 is a vector diagram for illustrating a distance measuring error and the distance measuring principle of the single side determination type fault locator;

Fig. 7 is a flowchart for illustrating the second operation of the apparatus of this invention;

Fig. 8 is a vector diagram showing an existence area of error;

Fig. 9 is a vector diagram showing an existence area of error;

Fig. 10 is a vector diagram for illustrating errors in respective terms constructing ΣIZ;

Fig. 11 is a vector diagram for illustrating errors in respective terms constructing ΣIZ;

Fig. 12 is a system diagram showing a case wherein voltage and current data on a point of the fault section of the transmission line cannot be directly obtained;

Fig. 13 is a flowchart for illustrating the first operation of the apparatus of this invention applied to the system shown in Fig. 12;

Fig. 14 is a flowchart for illustrating the second operation of the apparatus of this invention applied to the system shown in Fig. 12;

Fig. 15 is a flowchart for illustrating the third operation of the apparatus of this invention applied to the system shown in Fig. 12;

Fig. 16 is a flowchart for illustrating the fourth operation of the apparatus of this invention applied to the system shown in Fig. 12;

Fig. 17 is a flowchart for illustrating the fifth operation of the apparatus of this invention applied to the system shown in Fig. 12;

Fig. 18 is a flowchart for illustrating the sixth operation of the apparatus of this invention applied to the system shown in Fig. 12;

Fig. 19 is a flowchart for illustrating the process of an embodiment of this invention;

Fig. 20 is a flowchart for illustrating the process of another embodiment of this invention; and

Fig. 21 is a flowchart for illustrating the process of still another embodiment of this invention.

There will now be described an embodiment of this invention with reference to the accompanying drawings.

Since the construction of the apparatus of this invention is exactly the same as the conventional fault locator shown in Fig. 1, the detail explanation for the construction of the apparatus is omitted. The entire characteristic operation of this invention is effected in the processing unit 5 shown in Fig. 1 and the characteristic operation is explained in detail.

The operation effected in this invention is explained on the assumption that the terminals A and B in Fig. 1 are specified points A and B on the fault section of the transmission line, for example.

Fig. 3 is a flowchart for illustrating the first operation of the apparatus of this invention. In Fig. 3, only that portion which is associated with the hypothesis error calculation is shown and the operation associated with the fault determination is known in the art and is omitted here for brevity.

In the process 101, a fault point voltage $V_F$ is calculated. The fault point voltage $V_F$ calculated in the process 101 is a fault point voltage between the fault phases or the fault phase and the ground having the same phase as a voltage used for distance measurement by the fault locator to which this invention is applied. The fault point voltage $V_F$ may be calculated based on the following equation (4), for example.

$$V_F = V_A - XL\Sigma I_A Z \qquad (4)$$

In the equation (4), a value calculated by the fault locator is used as a value of XL. $V_A$ and $\Sigma I_A Z$ in the equation (4) are the same as $V_A$ and $\Sigma I_A Z$ in the equation (1) used for fault point determination by the fault locator to which this invention is applied and are associated with the fault phase.

In the process 102, the product $\Sigma IZ$ of preset phase currents I and an impedance Z of the transmission line causing a voltage drop in the fault phase voltage is calculated. In the single side determination type, a current $I_A$ in the specified point A can be used as the preset current I and $\Sigma I_A$ can be used as the product $\Sigma IZ$ as it is. In the both side comparison type, the sum of currents $I_A$ and $I_B$ at the specified points A and B is used as the preset current I and $\Sigma(I_A + I_B)Z$ is used as the product $\Sigma IZ$.

In the process 103, a value of an hypothesis error $Q_{VF}$ of the fault point voltage is calculated. The value calculated in the process 103 is expressed by the following equation (5).

$$Q_{VF} = K_{VF}V_F/\Sigma IZ \qquad (5)$$

In the equation (5), $K_{VF}$ is a positive constant. In general, the absolute value of the equation (5) is calculated as the hypothesis error $Q_{VF}$ of the fault point voltage, but in some cases, a phase difference between the currents $I_A$ and $I_B$ at the specified points A and B is detected by calculating the hypothesis error $Q_{VF}$ of the fault point voltage in the form of a complex number.

Referring to Fig. 3, concrete equations for calculation of the hypothesis error are shown below.

A distance measurement error caused by the fault point voltage of the fault locator used in the prior art in the single side determination type system is explained. In the case of occurrence of internal fault of the transmission line TL of Fig. 1, a voltage at the fault point and voltages and currents at the respective specified points have the relation expressed by the following equations (6) and (7).

$$V_F = V_A - XL\Sigma I_A Z \qquad (6)$$

$$V_F = V_B - (1-X)L\Sigma I_B Z \qquad (7)$$

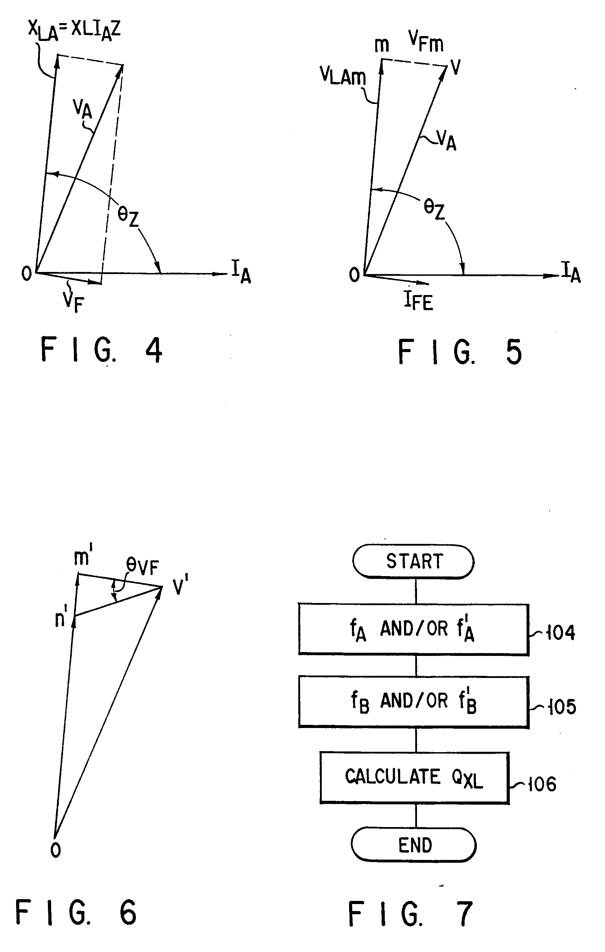

Fig. 4 is a vector diagram showing the relation between the voltage and current at a fault point and a specified point on the transmission line and showing the relation expressed by the equation (6). In Fig. 4, a voltage $V_{LA} = XL\Sigma I_A Z$ is a vector indicating a voltage drop in the transmission line from the specified point A to the fault point F. $V_{LA}$ has a leading phase by an angle $\theta_Z$ of the impedance Z with respect to the fault phase current $I_{AF}$ at the specified point A. Since the phase difference between the fault point voltage $V_F$ and the fault point current $I_F$ (not shown) is small and the phase difference between the fault point current $I_F$ and the fault phase current $I_{AF}$ is small, the phase difference between the fault point voltage $V_F$ and the current $I_{AF}$ becomes small as shown in Fig. 4. The voltage $V_B$ at the specified point A is equal to the sum of the voltages $V_{LA}$ and $V_F$ and has the relation shown in Fig. 4. In the single side determination type, the following equation (8) can be obtained by rewriting the equation (1). Further, the following equation (9) can be derived based on the equation (8).

$$\text{Im}[\{V_A - XL\Sigma I_A Z\}I_{FE}^*] = 0 \qquad (8)$$

$$\{V_A - XL\Sigma I_A Z\}I_{FE}^* = \{V_A - XL\Sigma I_A Z\}I_{FE}^2/I_{FE} = \text{real number} \qquad (9)$$

The equation (9) indicates that the voltage $V_{LA}$ isderived according to the equation (1) on the assumption that the current $I_{FE}$ is in phase (phase difference $0°$) with the fault point voltage $V_F$ in the equation (6) and the distance XL is calculated according to the following equation (10).

$$XL = V_{LA}/\Sigma I_A Z \quad (10)$$

Fig. 5 shows the above calculation method. In Fig. 5, an intersection m between a straight line passing an origin o and extending at an angle $\theta_Z$ with respect to the current $I_{AF}$ (not shown), that is, a straight line of $\Sigma I_A Z$ and a line parallel to $I_{FE}$ and extending from the top end v of the voltage $V_A$ is derived, a vector mv is used as a hypothesis value $V_{Fm}$ of the fault point voltage $V_F$ and an vector om is used as a hypothesis value $V_{LAm}$ of the voltage $V_{LA}$ of voltage drop in the transmission line.

The distance measurement error in the calculation method shown in Fig. 5 is explained. Assume that values indicated in the equation (1) and Fig. 5 and given under the influence of the distance measurement error are expressed as shown in the equations (11). In the equations (11), $\epsilon_{VA}$, $\epsilon_{IA}$ and $\epsilon_Z$ are complex numbers indicating the ratio of errors for $V_A$, $I_A$ and Z.

measured value of $V_A = V_{AM} = (1 + \epsilon_{VA})V_A$
measured value of $\Sigma I_A Z = (1 + \epsilon_{IA})(1 + \epsilon_Z)\Sigma I_A Z$
phase difference between $V_F$ and $V_{Fm} = \theta_{VF}$ $\quad (11)$

Fig. 6 is a diagram showing a voltage and a hypothesis voltage when the above-described errors are present and corresponds to Fig. 5.

In Fig. 6, a vector oV' indicates a voltage input $(1 + \epsilon_{VA})V_A$ at the point A. A vector on' indicates a hypothesis value of a voltage of voltage drop in the transmission line occurring when the hypothesis fault point voltage $V_{Fm}$ has no phase difference and $\theta_{VF} = 0°$ and the value thereof is given by $(1 + \epsilon_{VA})V_{LA}$. At this time, a vector n'V' is given by $(1 + \epsilon_{VA})V_F$. A vector n'm' indicates an apparent voltage $V_{VLA}$ of voltage drop in the transmission line caused by the fault point voltage $V_F$ by the phase error $\theta_{VF}$ of $V_{Fm}$ and the voltage $V_{VLA}$ of voltage drop in the transmission line is expressed by the equation (12).

In the equation (12), $f(\theta_{VF})$ is a function of $\theta_{VF}$ in which the value is set to 0 when $\theta_{VF} = 0$.

$$V_{VLA} = (1 + \epsilon_{VA}) \times f(\theta_{VF})V_F \quad (12)$$

In the example of Fig. 6, since $\theta_{VF}$ is small and an angle between the line om' and the line m'v' is approx. $90°$, $f(\theta_{VF})$ is substantially proportional to $\theta_{VF}$. However, since the voltage $V_{VLA}$ has an error as indicated by the equation (12), a value of distance $XL_m$ containing an error as indicated by the equation (13) is calculated as a value of the distance XL in the equation (10). In this case, in the equation (13), $\epsilon_{XL}$ is a complex number indicating the ratio of the error in the calculated distance XL.

$$X_L = (1 + \epsilon_{XL})XL$$
$$= (1 + \epsilon_{VA})\{(f(\theta_{VF})V_F + V_{LA}\}/(1 + \epsilon_{IA})(1 + \Sigma_Z)\Sigma I_A Z$$
$$--- (13)$$

A determination error (error of the calculated distance) $_{XL}XL$ is a difference between the equation (13) and the equation (10) and is given according to the equation (14) based on the equations (13) and (19).

$$\epsilon XL = \{(1 + \epsilon_{VA})f(\theta_{VF}V_F + \epsilon_{VA}-\epsilon_{IA}-\epsilon_Z-\epsilon_{IA}\epsilon_Z)V_{LA}\} /\{(1 + \epsilon_{IA})(1 + \epsilon_Z)\Sigma I_A Z\} \quad (14)$$

Since $XL = V_{LA}/I_A Z$ in the equation (14), the equation (14) can be rewritten into the equation (15).

$$\epsilon = \eta_{VF}/\Sigma I_A Z + \epsilon_{XL} \quad (15)$$

Assuming that the values of $\epsilon_{VA}$, $\epsilon_{IA}$ and $\epsilon_Z$ are set to be sufficiently smaller than 1 in the equation (15), then the following equations (16) and (17) can be obtained.

$$\eta_{VF} \fallingdotseq f(\theta_{VF}) \quad (16)$$

9

$$\epsilon_{EA} = \epsilon_{VA} - \epsilon_{IA} - \epsilon_Z \qquad (17)$$

Next, the calculation method for a hypothesis error $Q_{VF}$ of the fault point voltage in the single side determination type is explained.

The following equation (18) can be obtained by substituting the equation (5) into the equation (15) on the assumption that the constant $K_{VF}$ in the equation (5) is equal to $\eta_{VF}$ and the product $\Sigma IZ$ is equal to the product $\Sigma I_A Z$.

$$\epsilon_{XL} XL = Q_{VF} + \epsilon_{EA} XL \qquad (18)$$

As described above, if the hypothesis value of $\eta_{VF}$ is $K_{VF}$, a value of the hypothesis error $Q_{VF}$ which is a hypothesized value of the error of the first term of the equation (15) can be calculated. Therefore, a value of hypothesis error caused by the fault point voltage $V_F$ inthe single side determination type fault locator can be derived by using a preset current as the current $I_A$ at the point A of the fault section of the transmission line and using a value of $Q_{VF}$ calculated in the process 103 of Fig. 3.

A value of distance measurement error caused by the fault point voltage is small when the fault point voltage $V_F$ is sufficiently low. However, a simulation current $I_{FE}$ is generally derived as a variation component of the current in the fault from the current before occurrence of the fault but it is not always in phase with the fault point current $I_F$. The fault point voltage $V_F$ is generally treated as a voltage which is in phase with the fault point current $I_F$, but it has a leading phase of approx. 10° in the fundamental component caused by the non-linearity of fault point arc resistance, for example. For this reason, the value of $\eta V_F$ often becomes larger by one order than the value of $\epsilon_{EA}$ and sometimes becomes unexpectedly large when the fault point voltage $V_F$ is high, particularly in the case of tree-contact fault.

As described above, the value of the hypothesis error $Q_{VF}$ becomes extremely different depending on the state at the time of fault. In addition, the hypothesis error $Q_{VF}$ provides information used for estimating a hypothesis error of the distance measurement error caused in the fault point voltage which is difficult to be hypothesized from the value of the measured distance. Therefore, the information is used as information which is extremely effective for inspection of the fault point.

A calculation method for distance measurement error of the both side comparison type is explained. In this invention, consider a case where input data expressed by the equation (3) is given by the equations (11) and (19).

measurement value of $V_B = V_{BM} = (1 + \epsilon_{VB}) V_B$

measurement value of $I_B Z = (1 + \epsilon_{IB})(1 + \epsilon_Z) \Sigma I_B Z \qquad (19)$

In the equation (19), $\epsilon_{VB}$ and $\epsilon_{IB}$ are complex numbers indicating the ratios of errors of the measured values of $V_B$ and $I_B$. The calculated distance at this time can be given by the following equation (20).

$$(1 + \epsilon_{XL}) XL = \{(1 + \epsilon_{VA}) V_A - (1 + \epsilon_{VB}) V_B + L(1 + \epsilon_{IB})(1 + \epsilon_Z) \Sigma I_B Z\} / \{(1 + \epsilon_{IA}) \Sigma I_A Z + (1 + \epsilon_{IB}) \Sigma I_B Z\}(1 + \epsilon_Z) \qquad (20)$$

In this case, the distance measurement error is derived as follows.

Since the distance measurement error is a difference between the equations (20) and (3), $\epsilon_{XL}$ can be derived by the following equation (21) if the magnitudes of $\epsilon_{VA}$, $\epsilon_{VB}$, $\epsilon_{IB}$ and $\epsilon_Z$ are sufficiently smaller than 1.

$$\epsilon_{XL} = [\{(1 + \epsilon_{VA}) V_A - (1 + \epsilon_{VB}) V_B + L(1 + \epsilon_{IB} + \epsilon_Z) \Sigma I_B Z\} \times \Sigma (I_A + I_B) Z - (V_A - V_B + L \Sigma I_B Z) \times \{(1 + \epsilon_{IA} + \epsilon_Z) \Sigma I_A Z + (1 + \epsilon_{IB} + \epsilon_Z) \Sigma I_B Z\}] / \{(1 + \epsilon_{IA} + \epsilon_Z) \Sigma I_A Z + (1 + \epsilon_{IB} + \epsilon_Z) \Sigma I_B Z\} \times \Sigma (I_A + I_B) Z \qquad (21)$$

The numerator of the equation (21)

$$= \{(\epsilon_{VA} - \epsilon I A_{IA} - \epsilon_Z) \Sigma I_A Z + (\epsilon_{VA} - \epsilon_{IB} - \epsilon_Z) \Sigma I_B Z\} V_A - \{(\epsilon_{VA} - \epsilon I A_{IA} - \epsilon_Z) \Sigma I_A Z + (\epsilon_{VB} - \epsilon_{IB} - \epsilon_Z) \Sigma I_B Z\} V_B + (\epsilon_{IB} - \epsilon_{IA})\{X + (1-X)\} L \Sigma I_A Z \times \Sigma I_B Z \qquad (22)$$

The following equation (23) can be obtained by using the equations (6) and (7) and canceling $V_A$ and $V_B$ in the equation (22).

Equation (22) $= (\epsilon_{VA} - \epsilon_{VB}) V_F + \Sigma (I_A + I_B) Z + (\epsilon_{VA} - \epsilon_{IA} - \epsilon_Z) \times L \times \Sigma (I_A + I_B) Z \times \Sigma I_A Z - (\epsilon_{VB} - \epsilon_{IB} - \epsilon_Z)(1-X) L \times \Sigma (I_A + I_B) Z \qquad (23)$

Therefore, $\epsilon_{XL}XL$ can be obtained by the following equation (24).

$$\epsilon_{XL}XL = [\{(\epsilon_{VA}\text{-}\epsilon_{VB})V_F + (\epsilon_{VA}\text{-}\epsilon_{IA}\text{-}\epsilon_Z)XL\Sigma I_A Z \quad \text{-}(\epsilon_{VB}\text{-}\epsilon_{IB}\text{-}\epsilon_Z)(1\text{-}X)L\Sigma I_B Z] \quad /\{(1+\epsilon_{IA}+\epsilon_Z)\Sigma I_A Z + \text{-}(1+\epsilon_{IB}+\epsilon_Z)\Sigma I_B Z\} \quad (24)$$

If $(1+\epsilon_{IA}+\epsilon_Z)$ and $(1+\epsilon_{IB}+\epsilon_Z)$ are approximately equal to 1 in the equation (24), the following equations (25) and (26) can be obtained.

$$\epsilon_{XL}XL = (\epsilon_{VA}\text{-}\epsilon_{VB})V_F/\{\Sigma(I_A+I_B)Z\}\ \epsilon_{EA}XL\Sigma I_A Z\text{-}\epsilon_{EB}(1\text{-}X)L\Sigma I_B Z/\{\Sigma(I_A+I_B)Z\} \quad (25)$$

where

$$\epsilon_{EA} = \epsilon_{VA}\text{-}\epsilon_{IA}\text{-}\epsilon_Z,\ \epsilon_{EB} = \epsilon_{VB}\text{-}\epsilon_{IB}\text{-}\epsilon_Z \quad (26)$$

Next, a method of calculating a hypothesis error for the fault point voltage in the both comparison type system is explained.

In the equation (25), the first term on the right side indicates an error caused by the fault point voltage $V_F$. As shown in the equation (5) of the process 103, a hypothesis value of the first term on the right side of the equation (25) can be obtained and a hypothesis value of an error caused by the fault point voltage can be given by setting the preset current as the sum $(I_A+I_B)$ obtained by adding currents on both sides of the fault point in the transmission line, setting $\Sigma IZ$ as $(I_A+I_B)Z$, and calculating a hypothesis error $Q_{VF}$ by use of the constant $K_{VF}$ as a hypothesis value of $(\epsilon_{VA}\text{-}\epsilon_{VB})$.

As described above, this invention adequately indicates a hypothesis value of an error caused by the fault point voltage which significantly varies depending on the phenomenon of fault.

Fig. 7 is a flowchart showing the second operation of the apparatus of this invention. The second operation is applied only to the both side comparison type.

In the process 104, values of functions $f_A$ and/or $f_A{}'$ expressed by the equations (27) and (28) are calculated.

$$f_A = XL\Sigma I_A Z \quad (27)$$

$$f_A{}' = XL\Sigma|I_A Z| \quad (28)$$

In the equation (28), $\Sigma|IZ|$ indicates the sum of magnitudes of $\Sigma IZ$ and it is expressed by the equation (29) when $\Sigma IZ$ is given by the equation (2).

$$\Sigma|IZ| = |IaaZaa| + |Ibzab| + |IcZac| \quad (29)$$

In the process 105, values of functions $f_{VB}$ and/or$f_B{}'$ expressed by the equations (30) and (31) are calculated.

$$f_B = (1+X)L\Sigma I_B Z \quad (30)$$

$$f_B{}' = (1+X)L\Sigma|I_B Z| \quad (31)$$

In the process 106, a distance proportional hypothesis error $Q_{XL}$ is calculated by use of the equation (32).

$$Q_{XL} = \text{a value calculated by using the sum of a function of \{term of } f_A \text{ (and/or) } f_A{}'] /\{\text{term of } \Sigma (I_A+I_B)Z\}$$
and a function of {term of $f_A$ (and/or) $f_A{}'$] /{term of $\Sigma (I_A+I_B)Z$} (32)

Various methods for actual calculation of the distance proportional hypothesis error $Q_{XL}$ according to the equation (32) are provided as follows.

The first method is a method for deriving the distance proportional hypothesis error $Q_{XL}$ as the quotient of the sum of the magnitudes of values proportional to both terms $f_A$, $f_B$ in the equation (32) divided by $|\Sigma(I_A+I_B)Z|$ as shown in by the equation (33), for example.

$$Q_{XL} = \{|K_A X L \Sigma I_A Z| + |K_B(1-X)L\Sigma I_B Z|\} / |\Sigma(I_A + I_B)Z| \qquad (33)$$

where $K_A$ and $K_B$ are positive constants.

The second method is a method for deriving the distance proportional hypothesis error $Q_{XL}$ by adding the sum of the magnitudes (absolute values) of values obtained by adding together values in the vector form respectively proportional to the both terms to the numerator of the equation (33) as shown by the equation (34).

$$Q_{XL} = (|K_A' X L \Sigma I_A Z - K_B'(1-X)L\Sigma I_B Z| + |K_A X L \Sigma I_A Z| + |K_B(1-X)L\Sigma I_B Z|\} / |\Sigma(I_A + I_B)Z| \qquad (34)$$

where $K_A'$ and $K_B'$ are constants of complex numbers.

The third method is a method for deriving the distance proportional hypothesis error $Q_{XL}$ by changing the term of the numerator of the equation (33) from $|\Sigma I Z|$ to the sum $\Sigma|IZ|$ of magnitudes of the respective terms thereof as shown by the equation (35).

$$Q_{XL} = \{|K_A X L \Sigma |I_A Z| - K_B(1-X)L\Sigma|I_B Z| |\} / |\Sigma(I_A + I_B)Z| \qquad (35)$$

The fourth method is a method for deriving the distance proportional hypothesis error $Q_{XL}$ by changing the second and third terms of the numerator of the equation (34) from $|\Sigma I Z|$ to the sum $\Sigma|IZ|$ of magnitudes of the respective terms thereof as shown by the equation (36).

$$Q_{XL} = \{|K_A' X L \Sigma I_A Z - K_B'(1-X)L\Sigma I_B Z| + K_A X L \Sigma |I_A Z| + |K_B(1-X)L\Sigma |I_B Z| |\} / |\Sigma(I_A + I_B)Z| \qquad (36)$$

The fifth method is a method for deriving the distance proportional hypothesis error $Q_{XL}$ as a root mean square value of the terms respectively proportional to the terms of both functions as shown by the equation (36a).

$$Q_{XL} = [(K_A X L \Sigma I_A Z)^2 + \{K_B(1-X)L\Sigma I_B Z\}^2]^{1/2} / |\Sigma(I_A + I_B)Z| \qquad (36a)$$

In addition, the function of the equation (32) is not limited to a linear function, the sum of added values is not necessarily output as it is, and it may be output after subjected to the preset operation.

Further, instead of adding the terms respectively proportional to the both terms as indicated by the equation (36a), it is also possible to independently calculate the distance proportional hypothesis errors $Q_{XLA}$ and $Q_{XLB}$ at the specified points A and B as indicated by the equations (36b) and (36c) and leave the succeeding process to the operator's judgment.

$$Q_{XLA} = |K_A X L \Sigma I_A Z / \Sigma(I_A + I_B)Z| \qquad (36b)$$

$$Q_{XLB} = |K_B(1-X)L\Sigma I_B Z / \Sigma(I_A + I_B)Z| \qquad (36c)$$

The distance measurement error in the both side comparison type is expressed by the equation (25) as described before, and the second term of the right side corresponds to the distance proportional error. The numerator of the second term of the equation (25) is the sum of $\epsilon_{EA} X L \Sigma I_A Z$ which is the term of $f_A$ of the equation (27) and $-\epsilon_{EB}(1-X)L\Sigma I_B Z$ which is the term of $f_B$ of the equation (30). The construction of the numerator of the second term becomes the same as the construction of the equation (32). In the process 106 of Fig. 7, the distance proportional hypothesis error $Q_{XL}$ is calculated in the form of equation (32) as described above.

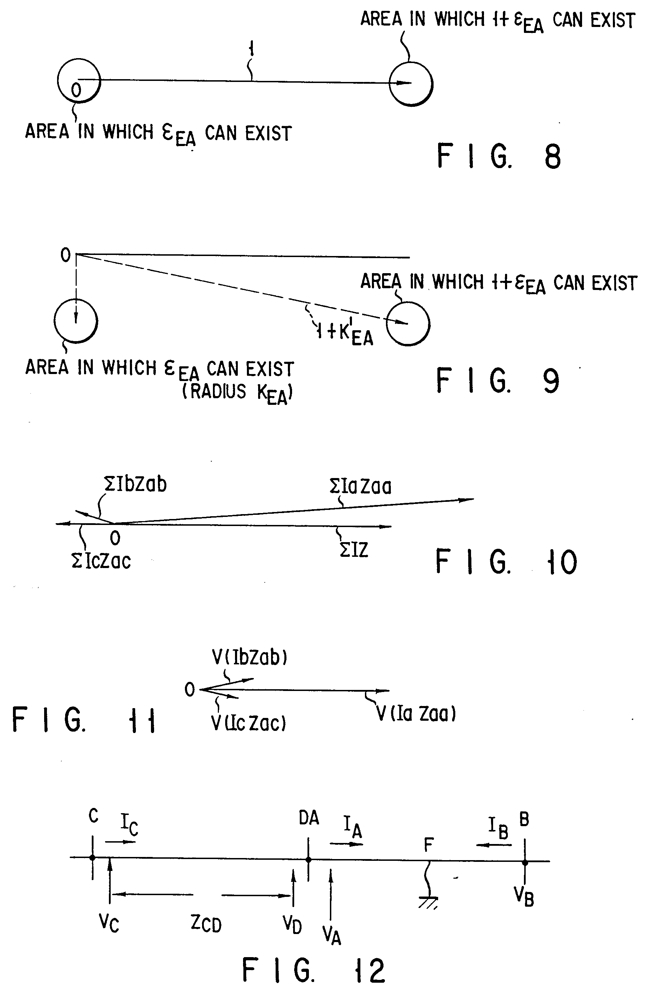

The equation (33) is used when it is assumed as shown in Fig. 8 that the values of $\epsilon_{EA}$ and $\epsilon_{EB}$ of the equation (25) have desired phase angles and magnitudes smaller than a constant value $K_{EA}$. In this case, if the phase angles of both values are set equal to each other, the numerator of the second term of the equation (25) may be changed to the state expressed by the following equation (37).

$$|\epsilon_{EA} X L \Sigma I_A Z - \epsilon_{EB}(1-X)L\Sigma I_B Z| = |\epsilon_{EA} X L \Sigma I_A Z| + |\epsilon_{EB}(1-X)L\Sigma I_B Z| \qquad (37)$$

The equation (33) is an equation for calculating a hypothesis error by using hypothesis values of the magnitudes of $\epsilon_{EA}$ and $\epsilon_{EB}$ in the equation (37). The equation (34) is used when values of $\epsilon_{EA}$ and $\epsilon_{EB}$ are hypothesized to exist in circles having vectors $K'_{EA}$ and $K'_{EB}$ set as the centers and radius of $K_{EA}$ and $K_{EB}$ on a complex number plane as shown in Fig. 9 (only the former case is shown in Fig. 9). This hypothesis is

used when $\epsilon_{EA}$ and $\epsilon_{EB}$ have constant tendencies but vary in the limited range. The condition in this case is mathematically expressed by the following equation (38).

$$|\epsilon_{EA}-K'_{EA}| \leq K_{EA}, |\epsilon_{EB}-K_{EB}'| \leq K_{EB} \qquad (38)$$

where $K'_{EA}$ and $K'_{EB}$ are complex numbers and $K_{EA}$ and $K_{EB}$ are positive constants.

The numerator of the second term of the equation (25) is expressed by the following equation (39).

$$\epsilon_{EA}XL\Sigma I_A Z-\epsilon_{EB}(1-X)L\Sigma I_B Z = \{K_{EA}'XL\Sigma I_A Z-K_{EB}'(1-X)L\Sigma I_B Z\} + (\epsilon_{EA}-K_{EA}')XL\Sigma I_A Z-(\epsilon_{EB}-K_{EB}')(1-X)L\Sigma I_B Z \qquad (39)$$

The first term $\{K'_{EA}XL\Sigma I_A Z-K_{EB}'(1-X)L\Sigma I_B Z\}$ of the equation (39) is a single vector determined by $XL\Sigma I_A Z$ and $(1-X)L\Sigma 2I_B Z$. In the second and third terms, $(\epsilon_{EA}-K_{EA}')$ and $(\epsilon_{EB}-K_{EB}')$ have desired phase angles and magnitudes smaller than a constant value like $\epsilon_{EA}$ and $\epsilon_{EB}$ in the case of Fig. 8. Under this condition, the phase differences between the first, second and third terms of the equation (39) take desired values and a condition indicated by the equation (40) may be set up.

$$\text{Equation (39)} = |K_{EA}'XL\Sigma I_A Z-K_{EB}'(1-X)L\Sigma I_B Z| + |(\epsilon_{EA}-K_{EA}')XL\Sigma I_A Z| + |(\epsilon_{EB}-K_{EB}')(1-X)L\Sigma I_B Z)| \qquad (40)$$

The equation (34) is used to derive a hypothesis error on the above hypothesis.

The effect obtained when a distance proportional hypothesis error $Q_{XL}$ is calculated by use of the equation (35) is explained.

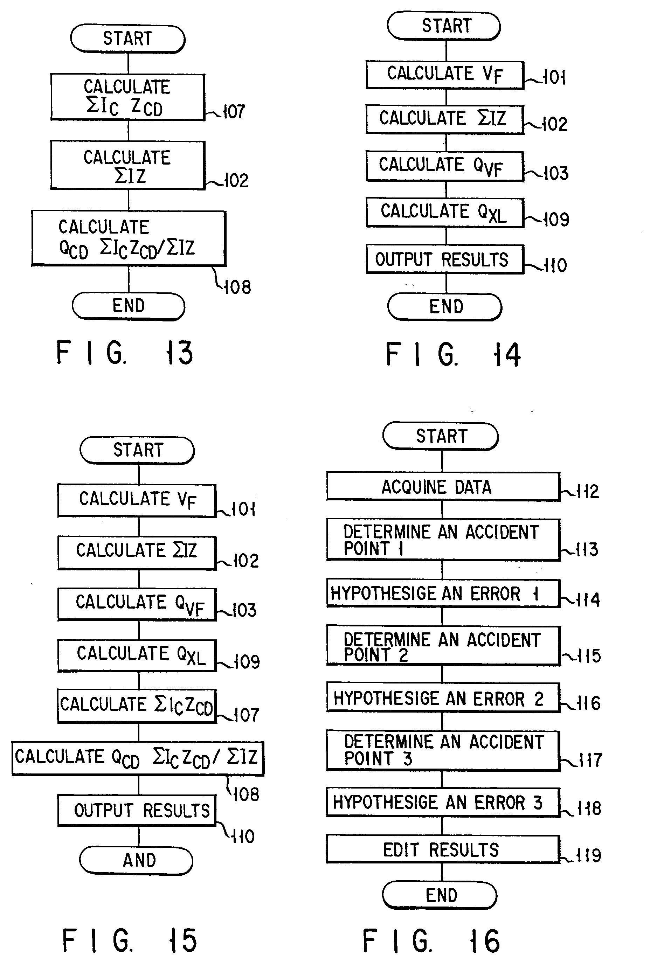

In the case of both side comparison type, if a data acquiring error is hypothesized as indicated by the equations (11) and (19), the distance proportional hypothesis error can be expressed by the second term of the equation (25). However, $\Sigma I_A Z$ and $\Sigma I_B Z$ which are the numerator thereof are constructed as indicated by the equation (2), for example. Like an example of Fig. 10, in the respective terms of the equation (2), IaZa is positive and IbZab and IcZac are negative to cancel each other in many cases. In this case, the magnitude $|\Sigma IZ|$ of the sum of the respective terms is slightly smaller than the sum $\Sigma|IZ|$ of the magnitudes of the respective terms. In this case, if errors caused by the respective terms are hypothesized to have desired phase angles and magnitudes smaller than a constant value as shown in Fig. 8, errors V(IaZaa), V(IbZab) and V(IcZac) caused by the respective terms are set in such directions as to be added together as shown in Fig. 11. The equation (33) is used to effect the simplified process by paying much attention to a fact that an influence on the fault phase by the other phases is not so serious, and the constants $K_A$ and $K_B$ must be set to correspondingly larger values. In contrast, in the equation (35), since the magnitude of the distance proportional hypothesis error $Q_{XL}$ is set to be proportional to the sum of the magnitudes of respective terms of $\Sigma|IZ|$, the constants $K_A$ and $K_B$ are set to proper values and a more adequate hypothesis error can be obtained.

Next, the effect obtained when the distance proportional hypothesis error $Q_{XL}$ is derived by using the equation (36) is explained.

The equation (36) is an equation obtained by replacing $|\Sigma IZ|$ of the second and third terms of the numerator of the equation (34) by the sum $\Sigma|IZ|$ of the magnitudes of the respective terms. The effect obtained by using $\Sigma|IZ|$ is the same as that obtained in the case of the equation (35), and when errors of the respective terms of $\Sigma IZ$ are hypothesized as shown in Fig. 9, the equation (36) can provide more adequate errors than the equation (34).

Next, a method for calculating the distance proportional hypothesis error $Q_{XL}$ by using the equations (36a) to (36c) is explained. The equation (36a) is an equation for treating the root mean square value of both terms proportional to $f_A$ and $f_B$ constructing the distance proportional hypothesis error $Q_{XL}$ as a hypothesis error. The equations (36b) and (36c) are used to independently calculate the respective terms proportional to $f_A$ and $f_B$ constructing the distance proportional hypothesis error $Q_{XL}$. The respective calculated values can be processed in the same manner as in the cases of equations (32) to (36a) or may be used to independently recognize the degree of the error. As described above, concrete execution means can be variously modified.

Fig. 12 is a systematic diagram showing a case wherein voltage and current data on the fault section of the transmission line cannot be directly obtained.

In Fig. 12, a section between points A and B is a fault section of the transmission line, and a section between points C and D is a sound section of the transmission line. Assume that voltages at the points A and D are equal to each other and no current flows from the points A and D. Voltage and current data at the points A and D cannot be directly obtained and voltage and current data at the points A and D can be indirectly created based on data at the point C. This construction appears in the case of a 2-terminal transmission line in which the construction of the transmission line is extremely different in portions divided by the points A and B, for example, a section between the points C and D is a cable line and a section between the points A and B is an aerial line.

Fig. 13 is a flowchart for illustrating the first operation of the apparatus of this invention applied to the system shown in Fig. 12. In Fig. 13, portions which are the same as those of Fig. 3 are denoted by the same reference numerals and the detail explanation is omitted.

In the process 107, a value of the product $\Sigma I_C Z_{CD}$ (or the sum $\Sigma|I_C Z_{CD}|$ of the magnitudes of the respective terms thereof) of the current $I_C$ at the point C and the impedance $Z_{CD}$ showing a voltage drop for the fault phase between the points C and D is calculated.

In the process 108, a value of the sound section hypothesis error $Q_{CD}$ of the following equation (41) is calculated by use of a value of the product $\Sigma IZ$ using a preset current I obtained in the process 102 and a value obtained in the process 107.

$$Q_{CD} \alpha \Sigma I_C Z_{CD} \text{ (or } \Sigma|I_C Z_{CD}|)/\Sigma IZ \qquad (41)$$

In the single side determination type, the preset current I is set as a current $I_A$ (which is equal to $I_C$ in the condition described before) flowing from the point A towards the fault point and $Q_{CD}$ is derived based on the following equation (42).

$$Q_{CD} = K_{CD}\Sigma I_C Z_{CD} \text{ (or } K_{CD}\Sigma(I_C Z_{CD}|)/\Sigma I_A Z \qquad (42)$$

where $K_{CD}$ is a positive constant.

In the both side comparison type, a preset current I is set as the sum of a current $I_A$ flowing from the point A towards the fault point and a current $I_B$ flowingfrom a point B which lies on the opposite side of the point A with respect to the fault point towards the fault point and $Q_{CD}$ is derived based on the equation (43), for example.

$$Q_{CD} = K_{CD}\Sigma I_C Z_{CD} \text{ (or } K_{CD}\Sigma|I_C Z_{CD}|)/\Sigma(I_A + I_B)Z \qquad (43)$$

The operation of the process of Fig. 13 is explained with reference to the systematic diagram of Fig. 12.

In the case of fault of Fig. 12, the fault locator calculates a voltage $V_A$ based on a voltage $V_C$ and current $I_C$ at the point C according to the equation (44).

$$V_A = V_C - \Sigma I_C Z_{CD} \qquad (44)$$

In the equation (44), the measurement value $V_{AM}$ of $V_A$ can be derived based on the equation (45) by taking an error into consideration.

$$V_{AM} = (1 + \epsilon_{VC})V_C - (1 + \epsilon_{IC}(1 + \epsilon_{ZCD})\Sigma I_C Z_{CD} \qquad (45)$$

In the equation (45), $\epsilon_{VC}$, $\epsilon_{IC}$, $\epsilon_{ZCD}$ are complex numbers indicating the ratios of errors of $V_C$, $I_C$, $Z_{CD}$. Since $V_C - V_A = V_C - V_D = \Sigma I_C Z_{CD}$, $V_{AM}$ can be derived by the following equation (46).

$$V_{AM} = (1 + \epsilon_{VC})(V_A + \Sigma I_C Z_{CD}) - (1 + \epsilon_{IC})(1 + \epsilon_{ZCD})\Sigma I_C Z_{CD} \fallingdotseq (1 + \epsilon_{VC})V_A + \epsilon_{CD}\Sigma I_C Z_{CD} \qquad (46)$$

where

$$\epsilon_{CD} = \epsilon_{VC} - \epsilon_{IC} - \epsilon Z_{CD} \qquad (47)$$

In the equation (47), if $\epsilon_{VC}$ and $\epsilon_{VA}$ are equal to each other, the equation (46) becomes equivalent to an equation obtained by adding a voltage $\epsilon_{CD}\Sigma I_C Z_{CD}$ as an error in the equation (11). Therefore, in the equation (46), a calculated distance of the distance measurement calculation value for the voltage $\epsilon_{CD}\Sigma I_C Z_{CD}$ is added as an error $E_{CD}$. The sound section hypothesis error $Q_{CD}$ of the equation (41) calculated in the process 108 indicates a hypothesis error for the added error $E_{CD}$.

In the single side determination type, the above error may be derived by rewriting the voltage $V_A$ in the equation (1) into $\epsilon_{CD}\Sigma I_C Z_{CD}$ and is given by the following equation (48).

$$E_{CD} = Im[\epsilon_{CD}\Sigma I_C Z_{CD} \times I_{EF}{}^*]/Im[\Sigma I_A Z \times I_{EF}{}^*] \qquad (48)$$

14

Since a phase difference between $\Sigma I_A Z$ and $I_{EF}$ becomes slightly smaller than 90° when a phase difference between $\epsilon_{CD}\Sigma I_C Z_{CD}$ and $I_{EF}$ is 90°, the error $E_{CD}$ can be expressed by the following equation (49).

$$E_{CD} \fallingdotseq \epsilon_{CD}\Sigma I_C Z_{CD}/\Sigma I_A Z \qquad (49)$$

The equation (42) is an equation for calculating the sound section hypothesis error $Q_{CD}$ in this condition. Further, in the both side comparison type, it is only necessary to set the numerator of the equation (3) to $\epsilon_{CD}\Sigma I_C Z_{CD}$ and the error $E_{CD}$ can be given by the following equation (50).

$$E_{CD} = \epsilon_{CD}\Sigma I_C Z_{CD}/\Sigma(I_A + I_B)Z \qquad (50)$$

The equation (43) is an equation for calculating the sound section hypothesis error $Q_{CD}$ in this condition.

Fig. 14 is a flowchart for illustrating the second operation of the apparatus of this invention applied to the system shown in Fig. 12 and portions which are the same as those of Fig. 12 are denoted by the same reference numerals.

In the processes 101 to 103, the fault point voltage hypothesis error $Q_{VF}$ is calculated in the same manner as in the case of Fig. 3. In the process 109, the distance proportional hypothesis error $Q_{XL}$ is calculated by using the equation (51).

$$Q_{XL} = f(XL) \qquad (51)$$

where f(XL) is a function of XL.

In the process 110, values obtained by subjecting the fault point voltage hypothesis error $Q_{VF}$ and distance proportional hypothesis error $Q_{XL}$ to the preset processes are output.

In the process 110, the error $Q_{VF}$ and the error $Q_{XL}$ are output in a combined form, or a total hypothesis error calculated by using a value obtained by adding the functions thereof together in the same unit, for example, a value such as $Q_M = Q_{VF} + Q_{VM}$ or $QM = (Q_{VF}^2 + Q_{XL}^2)^{1/2}$ is derived and output.

In the equation (51), $Q_{XL}$ is derived as a value which is proportional to a calculated distance XL from a specified point A at which a current $I_A$ flows in the case of single side determination type. That is, as shown in the following equation (52), it is determined as a value obtained by multiplying a constant value $K_A$ by XL.

$$Q_{XL} = K_A XL \qquad (52)$$

Further, it may be determined as a value obtained by multiplying a calculated distance XL by a value derived by adding a constant $K_A''$ to the product of the constant $K_A$ and the quotient of the magnitude $|\Sigma IZ|$ of $\Sigma IZ$ divided by the sum $\Sigma|IZ|$ of the magnitudes of respective terms of the product $\Sigma IZ$ as shown by the equation (53).

$$Q_{XL} = XL\{K_A'' + K_A\Sigma \, |IZ|/|IZ|\} \qquad (53)$$

In the both side comparison type, the error $Q_{XL}$ isa value obtained by the equation (32), and more specifically, the equations (33) to (36c). In this case, the operation of the process 109 is the same as that shown in Fig. 7.

As described above, in the operation shown in Fig. 14, the fault point hypothesis error $Q_{VF}$ and the distance proportional hypothesis error $Q_{XL}$ are output in a combined form, or a value $Q_M$ obtained by adding the functions thereof together in the same unit is output. As a result, the entire content of the hypothesis error can be detected in a case where a section of the system as shown in Fig. 12 is not provided in the transmission line.

In the case of the single side determination type, the distance proportional hypothesis error $Q_{XL}$ is proportional to the calculated distance XL. A value of the distance proportional hypothesis error $Q_{XL}$ of the equation (52) is an equation obtained by setting the hypothesis value of $\epsilon_{EA}$ of the second term of the right side of the equation (15) to a constant $K_A$. The hypothesis error $Q_{XL}$ is an equation obtained by setting the hypothesis error of $\Sigma I_A Z$ to vary in proportion to $\Sigma I_A Z$ as shown by the equation (11). In general, since an error caused by a current having the same phase as the fault phase voltage in the respective terms of $\Sigma I_A Z$is sufficiently larger than that caused by the current of the other phase, the hypothesis error of $\Sigma I_A Z$ can be treated as a value which is proportional to $\Sigma I_A Z$. However, strictly speaking, the error of $\Sigma I_A Z$ occurs for each term of $\Sigma I_A Z$ and the errors for the respective terms have the same phase angle and are added

15

together in some cases. In this case, the ratio of the hypothesis error of $\Sigma I_A Z$ when the ratio of the error for each term of $\Sigma I_A Z$ is set to a constant $K_A$ becomes $K_A \Sigma |I_A Z|/|\Sigma I_A Z|$. A value of the distance proportional hypothesis error $Q_{XL}$ of the equation (53) is an equation set up when taking the above condition into consideration.

In the both side comparison type, a value of the distance proportional hypothesis error $Q_{XL}$ is calculated based on the equation (32).

Fig. 15 is a flowchart for illustrating the third operation of the apparatus of this invention applied to the system shown in Fig. 12. The operation shown in Fig. 15 has the processes 107 and 108 of Fig. 12 added between the processes 109 and 110 of Fig. 14.

In the process 108, like the case of Fig. 12, a value of the sound section hypothesis error $Q_{CD}$ is calculated by use of values calculated in the processes 102 and 107. In the process 110, values obtained by subjecting the sound section hypothesis error $Q_{CD}$, fault point hypothesis error $Q_{VF}$ and distance proportional hypothesis error $Q_{XL}$ to the preset processes are output.

In the process 108, the errors $Q_{CD}$, $Q_{VF}$ and $Q_{XL}$ are output in a combined form, or a total hypothesis error calculated by using a value obtained by adding the functions thereof together in the same unit, for example, a value such as $Q_M = Q_{CD} + Q_{VF} + Q_{VM}$ or $Q_M = (Q_{CD}^2 + Q_{VF}^2 + Q_{XL}^2)^{1/2}$ is derived and output, or the sum of two functions, for example, $(Q_{CD} + Q_{XL})$ or $(Q_{CD}^2 + Q_{XL}^2)^{1/2}$ and the remaining function, for example, $Q_{VF}$ are output in a combined form.

As described above, in the case of Fig. 15, the fault point hypothesis error $Q_{VF}$, distance proportional hypothesis error $Q_{XL}$ and sound section hypothesis error $Q_{CD}$ are output in a combined form, or a value $Q_M$ calculated by using a value obtained by adding the three functions thereof together in the same unit is output. As a result, the entire content of the hypothesis error can be detected in a case where a section as shown in Fig. 12 is provided in the transmission line.

Fig. 16 is a flowchart for illustrating the fourth operation of the apparatus of this invention applied to the system shown in Fig. 12.

In the process 112, data necessary for fault point determination is acquired, three types of fault points are determined in the processes 113, 115 and 117, and hypothesis errors are calculated in the processes 114, 116 and 118. The fault point determination and hypothesis error calculation in each process are effected as follows, for example.

First, the fault point determinations 1 to 3 (processes 113, 115 and 117) are effected as follows.

Process 113: process of single side determination type using the equation (1).

Process 115: process which is the same as the process 108 except that data on the point B is used instead of data on the point A.

Process 117: process of both side comparison type using the equation (3).

Next, the error hypothesizing processes (processes 114, 116 and 118) are effected as follows.

Process 114: calculate the total hypothesis error $Q_M = Q_{VF} + Q_{XL}$ as $Q_{VF} = |K_{VF}/\Sigma I_A Z|$, $Q_{XL} = K_A XL$.

Process 116: process which is the same as the process 109 except that data on the point B is used instead of data on the point A.

Process 118: calculate the total hypothesis error $Q_M = Q_{VF}$ as $Q_{VF} = |K_{VF} V_F/\Sigma (I_A + I_B)Z|$, $Q_{XL}$ = the equation (33), (34), (35) or (36).

In the process 119, values of the calculated distance XL and total hypothesis error $Q_M$ calculated in the respective processes are output in a combined form. In this case, a calculated distance having a smaller hypothesis error $Q_M$ may be preferentially output. The method for setting priority order is effected by "outputting only the calculated distance of the determination means having the smallest total hypothesis error $Q_M$", "outputting all of the calculated distances of the determination means having determination errors smaller than a constant value", for example.

As described above, three types fault point determination means described as an example in Fig. 16 are different in the excellency of the hypothesis error depending on the condition of fault. That is, the magnitude of the total hypothesis error $Q_{MA}$ calculated in the process 114 by the single side determination type from the point A side using the equation (1) of the process 113 can be given by the following equation (54).

$$|Q_{MA}| = |K_{VF} V_F|/|\Sigma I_A Z| + |K_A XL| \qquad (54)$$

The magnitude of the total hypothesis error $Q_{MB}$ calculated in the process 116 by the single side determination type from the point B side in the process 110 can be given by the following equation (55).

$$|Q_{MB}| = |K_{VF} V_F|/|\Sigma I_B Z| + |K_B(1-X)L| \qquad (55)$$

The magnitude of the total hypothesis error $Q_{MAB}$ of the both side comparison type using the equation (3) in the process 113 is obtained based on the following equation (56) by using the equation (33) for $Q_{XL}$.

$$|Q_{MB}| = |K_{VF}V_F|/|\Sigma I_BZ| + \{|K_AXL\Sigma I_AZ| + |K_B(1-X)L\Sigma I_BZ|\} /|\Sigma(I_A + I_B)Z| \qquad (56)$$

In the equations (54) to (56), a value of error coefficient $K_{VF}$ is small in the equation (56) and large in the equations (54) and (55). For this reason, each of the hypothesis errors has the following tendency.

$Q_{MA}$ : this is small in a fault in which X is small in a case where the fault point voltage $V_F$ is low and the current $I_A$ is large.

$Q_{MB}$ : this is small in a fault in which (1-X) is small in a case where the fault point voltage $V_F$ is low and the current $I_B$ is large.

$Q_{MAB}$ : a large error does not occur when the fault point voltage $V_F$ is not so high and the value of hypothesis error does not become so small even in a fault in which X or (1-X) is small.

In the process 119 of Fig. 16, calculated distances by the above fault point determination means and respective hypothesis errors are output in a combined form. The calculated distance having the smallest hypothesis error is preferentially output. In either case, the calculated distance having the highest precision can be selectively used.

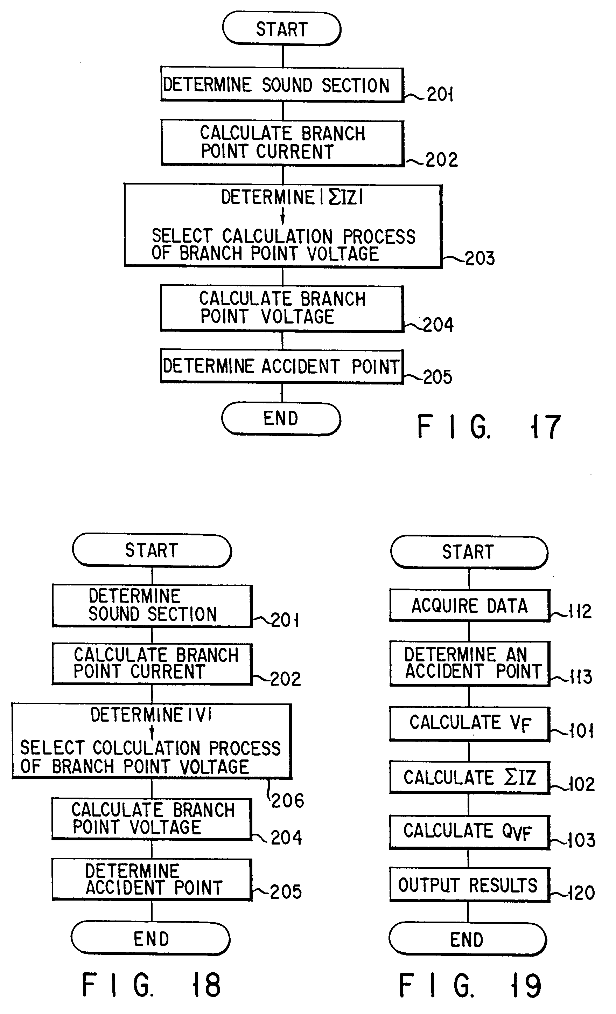

Fig. 17 is a flowchart for illustrating the fifth operation of the apparatus of this invention applied to the system shown in Fig. 12.

In the process 201, the sound section determination is effected. In the process 202, a branch point current value is calculated. In the process 203, the magnitude of a fault phase voltage drop in the sound section is determined and a branch point voltage calculation procedure to be used is selected. In the process 204, a branch point voltage value is calculated, and in the process 205, the fault point determination process is effected. The content of the process is concretely explained when the fifth operation is effected for the 3-terminal transmission line having terminals B, C and E as shown in Fig. 2 and a fault occurs between the terminal B and the branch point D.

In the process 201, voltages expressed by the equations (3a) to (3c) are compared with one another to identify a sound section. In this example, sections between C and D, and E and D are identified as a sound section. In the process 202, the sum $(I_C + I_E)$ of the terminal currents of the sound section is derived and the sum is treated as a current $I_D$ on the fault section side of the branch point. The processes 201 and 202 are the prior art technique, and therefore, the detail explanation therefore is omitted for brevity.

In the process 203, values of the fault phase voltage drops $\Sigma IZ$ of the respective sound sections are calculated, the magnitudes thereof are determined, and an operation procedure using a fault phase voltage drop of the sound section having a smaller magnitude is selected. In this example, the magnitudes of $\Sigma I_CZ_{CD}$ and $\Sigma I_EZ_{ED}$ of the equations (3b) and (3c) are determined. At this time, for example, if $|\Sigma I_CZ_{CD}| < |\Sigma I_EZ_{ED}|$, an operation procedure using $\Sigma I_CZ_{CD}$, that is, an operation procedure using the branch point voltage $V_{DC}$ of the equation (3b) as a branch point voltage $V_D$ is selected.

In the process 204, a value of the branch point voltage $V_D$ is calculated according to the operation procedure selected in the process 203. In the case of this example, the branch point voltage $V_D$ is derived as follows.

$$V_D = V_{DC}$$

In the process 205, a fault point is determined based on the prior art technique, for example, based on the equation (3) by using the branch point as a specified point A on the fault section, that is, using the voltage $V_D$ as a voltage $V_A$ and the current $I_D$ as a current $I_A$.

The operation shown in Fig. 17 is explained by taking a case of Fig. 2 as an example. The measurement value of the branch point voltage $V_{DC}$ calculated according to the equation (3b) becomes equal to the right side of the equation (46) when taking an error into consideration and the following equations can be obtained.

$$V_{DC} = (1 + \epsilon_{VC})V_D + \epsilon_{CD}\Sigma I_CZ_{CD} \qquad (56a)$$

$$V_{DE} = (1 + \epsilon_{VE})V_D + \epsilon_{ED}\Sigma I_EZ_{ED} \qquad (56b)$$

where $\epsilon_{VE}$ and $\epsilon_{ED}$ indicate the ratios of errors like $\epsilon_{VC}$ and $\epsilon_{CD}$ associated with data of the terminal E.

17

If the hypothesis values of $\epsilon_{VC}$ and $\epsilon_{VE}$ and the hypothesis values of $\epsilon_{CD}$ and $\epsilon_{ED}$ are equal to each other, one of the hypothesis values of errors of $V_{DC}$ and $V_{DE}$ becomes smaller than the other when a corresponding one of the values of the second terms $|\Sigma I_C Z_{CD}|$ and $|\Sigma I_E Z_{ED}|$ in the above equations is smaller than the other. For example, if $|\Sigma I_C Z_{CD}| < |\Sigma I_E Z_{ED}|$, the hypothesis value of error of $V_{DC}$ is smaller than the other and the error becomes small with high probability. Therefore, the fault point determination can be effected with the smallest error with high probability by using a voltage at a point at which the fault phase voltage drop of the transmission line with respect to the branch point is minimum and calculating the branch point voltage.

Fig. 18 is a flowchart for illustrating the sixth operation of the apparatus of this invention applied to the system shown in Fig. 12. In Fig. 18, portions which are the same as those of Fig. 17 are denoted by the same reference numerals and the detail explanation therefore is omitted. The sixth operation shown in Fig. 18 is similar to the operation shown in Fig. 17 except that the process 206 is effected instead of the process 203.

In the process 206 of Fig. 18, voltages V at the terminals of the sound sections are calculated, the magnitudes thereof are determined and an operation procedure using a voltage whose magnitude is minimum is selected. In the example of Fig. 2, if $|V_C| < |V_F|$, an operation procedure using the voltage $V_C$, that is, an operation procedure using the voltage $V_{DC}$ of the equation (3b) as a voltage $V_D$ is selected.

The above operation is concretely explained by using the system of Fig. 2 as an example.

In the normal case, the branch point voltage $V_D$ in the fault phase has substantially the same phase angle as the voltages $\Sigma I_C Z_{CD}$ and $\Sigma I_E Z_{EDB}$ representing voltage drops in the sound sections. For this reason, the fault phase voltage drop of the transmission line between the branch point and a point at which the fault phase voltage is lower is smaller. For example, if $|V_C| < |V_D|$, $|\Sigma I_C Z_{CD}| < |\Sigma I_E Z_{ED}|$ and the hypothesis value of an error is smaller for the branch point voltage $V_{DC}$ calculated by using a voltage $V_C$ which is a lower one of the fault phase voltages. Therefore, the fault point determination can be effected with the smallest error with high probability by calculating the branch point voltage by use of a voltage at one point which is included in a plurality of points having no fault point between the branch point and themselves and at which the fault phase voltage is minimum.

Now, a concrete embodiment of this invention is explained.

The hardware construction of this invention is the same as a general fault locator or digital relay throughout the embodiments explained below and is shown in Fig. 1, for example. The construction is known in the art and the detail explanation therefore is omitted for brevity.

A first embodiment in which this invention is applied to a single side determination type fault locator used for the terminal A of the single-circuit 2-terminal transmission line shown in Fig. 1 is explained. Fig. 19 is a flowchart for illustrating the process of the first embodiment. In Fig. 19, portions which are the same as those of Figs. 3 and 16 are denoted by the same reference numerals.

The process 112 is to acquire and store data of voltages and currents of respective phases of the terminals necessary for the fault point determination in the data acquiring process. In the process 112, data of voltages $V_{Aa}$, $V_{Ab}$ and $V_{Ac}$ and currents $I_{Aa}$, $I_{Ab}$ and $I_{Ac}$ of the respective phases a, b and c of the terminal A shown in Fig. 1 is acquired.

The process 113 is a fault point determination process to calculate a distance from the specified point A on the transmission line to the fault point to determine the fault point by use of known means using data acquired in the process 105. In the process 113, the fault phase is first determined when an internal fault occurs in the transmission line L. Next, the phases of the voltages, currents and impedances used for calculation are selected to effect the operation of the equation (1) and calculate a distance XL. In the selection of phases of the respective terms of the equation (1), $V_A$ is a fault phase voltage (a voltage between fault phases when faults of two or more phases occur), a current $I_{FE}$ is a variation ((current in fault)-(current before fault): this is the same in the following description), and $\Sigma I_A Z$ is the product of respective phase currents and self- or mutual impedances between the fault phase and the respective phases. This example is explained. Selection in the case of a phase fault is shown in the following.

$$V_A \text{ --- } V_{Aa} \qquad (57)$$

$$I_{FE} \text{ --- } \Delta I_{Aa} \text{ (a variation in } I_{Aa} \text{ and the variation is expressed } \Delta \text{ by in the following description)} \qquad (58)$$

$$\Sigma I_A Z \text{ --- } I_{Aa} Zaa + I_{Ab} Zab + I_{Ac} Zac \qquad (59)$$

Selection in the case of bc phase fault is made as follows.

$$V_A \text{ --- } V_{Ab} \text{-} V_{Ac} \qquad (60)$$

$I_{FE} \cdots \Delta I_{Ab} - \Delta I_{Ac}$     (61)

$\Sigma I_A Z \cdots I_{Aa}Zab + I_{Ab}Zbb + I_{Ac}Zbc - (I_{Aa}Zca + I_{Ab}Zcb + I_{Ac}Zcc)$     (62)

In the process 101, the fault point voltage $V_F$ is calculated based on the equation (4) by using a voltage $V_A$ which is the same as that used in the process 113, the product $\Sigma I_A Z$ of the current and the impedance, and calculated value XL. That is, $V_A$ and $\Sigma I_A Z$ are derived by using the equations (57) and (59) in the case of a phase fault and using the equations (60) and (62) in the case of bc phase fault. Thus, the fault point fault phase voltage $V_{Fa}$ or $V_{Fbc}$ is calculated. In the process 102, a calculated value $\Sigma I_A Z$ obtained in the calculation process of the process 113 is used as a value of the product $\Sigma IZ$ as it is. In the process 103, the above calculated values are used to calculate a value of the fault point voltage hypothesis error $Q_{VF}$ according to the equation (5).

The process 120 is an output process and adequately processes and outputs data calculated in the processes 106 and 103. That is, in the process 102, a value of $Q_{VF}$ and distance XL calculated in the process 113 are output.

A second embodiment in which this invention is applied to a both side comparison type fault locator used for the terminal A of the single-circuit 2-terminal transmission line shown in Fig. 1 is explained.

The process in the second embodiment is similar to the process of the first embodiment shown in Fig. 19, but the contents of the respective processes are different. In the process 112 of the second embodiment, data of voltages $V_{Ba}$, $V_{Bb}$ and $V_{Bc}$ and currents $I_{Ba}$, $I_{Bb}$ and $I_{Bc}$ of the respective phases of the terminal B is acquired in addition to data of voltages $V_{Aa}$, $V_{Ab}$ and $V_{Ac}$ and currents $I_{Aa}$, $I_{Ab}$ and $I_{Ac}$ of the respective phases of the terminal A. In the process 113, a fault phase is determined when an internal fault occurs, then the phases of the voltage, current and impedance are selected, and the operation of the equation (3) is effected to calculate a distance XL. Selection of the phases of the respective terms of the equation (3) is effected like the case of the first embodiment, the voltage is a fault phase voltage, and the product of the current and impedance is the sum of products of the respective phase currents and self- or mutual impedances between the respective phases and the fault phase. A case of a phase fault is shown below.

$V_A \cdots V_{Aa}$     (63)

$V_B \cdots V_{Ba}$     (64)

$\Sigma I_A Z \cdots I_{Ba}Zaa + I_{Bb}Zab + I_{Bc}Zac$     (65)

In the process 101, a fault point voltage $V_F$ is calculated according to the equation (4) or the following equation (66)

$V_F = V_B - (1-X)L\Sigma I_B Z$     (66)

The equation (66) is similar to the equation (4) except that the calculation is effected by use of values for the terminal B. In the equation (66), the phase selection is the same as described before, and in the case of a phase fault, for example, the equations (64) and (65) are used for the respective terms of the right side. One of the equations (4) and (66) which corresponds to a smaller one of the second terms $XL\Sigma I_A Z$ and $(1-X)L\Sigma I_B Z$ is generally selected and used. In the process 102, a value of $\Sigma(I_A + I_B)Z$ is calculated. The phase selection at this time is also made in the same manner as described before. A value of $\Sigma(I_A + I_B)$ becomes 0 in the sound section if the charging current is neglected so that only the fault phase currents will be added when the charging current can be neglected. For example, when the a phase is grounded, the following equation (67) is obtained.

$\Sigma(I_A + I_B)Z \cdots (I_{Aa} + I_{Ba})Zaa$     (67)

In the process 103, a value of the fault point voltage hypothesis error $Q_{VF}$ is calculated according to the equation (5) by using values calculated by the equations (66) and (67). In the process 107, values of $Q_{VF}$ and the determination distance are output in the same manner as in the case of the first embodiment.

The third embodiment is explained below. Also, in the third embodiment, selection of the phases used for the operation, data acquisition and fault point determination is effected like the first and second embodiments. In the process 110 of Figs. 14 and 15, a value obtained by combining or adding together various hypothesis errors $Q_{VF}$, $Q_{XL}$ and $Q_{CD}$ is output. In this case, particularly, in the case of addition, the units of the respective values of the various hypothesis errors must be the same. For this reason, the units of the respective amounts are standardized as follows, for example, and values of the respective hypothesis errors are calculated.

Length of the transmission line : kilometers;

Voltage : volts;

Current : amperes:

Impedance : ohms/kilometer.

The other portion is the same as the content explained in the item of the means for attaining the object and the detail explanation therefore is omitted for brevity.

Next, the fourth embodiment in which this invention is applied to a parallel 2-circuit transmission line is explained. In this embodiment, current data of a circuit adjacent to the parallel 2-circuit transmission line is acquired in addition to current and voltage data of its own circuit. The acquiring means is well known in the art and the explanation therefore is omitted for brevity. The flowchart of the process is the same as that for the single-circuit transmission line shown in Fig. 19, but the contents of the respective processes are different. The difference between this embodiment and the first embodiment in the case of single side determination type is explained.

In the process 112, current data items $I_{Aa}'$, $I_{Ab}'$ and $I_{Ac}'$ of terminals of the adjacent circuit of the terminal A are additionally acquired. In the processes 113, 101 and 102, terms of fault phase voltage drops in its own circuit are added in the product $\Sigma I_A Z$ representing the voltage drop. For example, in the case of a phase fault, it can be expressed by the following equation (68).

$$\Sigma I_A Z \;\text{---}\; I_{Aa} Z_{aa} + I_{Ab} Z_{ab} + I_{Ac} Z_{ac} + I_{Aa}' Z_{aa}' + I_{Ab}' Z_{ab}' + I_{Ac}' Z_{ac} \qquad (68)$$

In the equation (68), Zaa', Zab' and Zac' are mutual impedances in the unit length between the a phase of its own circuit and the a, b and c phases of the adjacent circuit.

The equation (68) is an equation for indicating the a phase voltage drop in the unit length in the parallel 2-circuit transmission line and is used for determination of the fault point, calculation of fault point voltage and calculation of the maximum error in exactly the same manner as in the case of the equation (59) in the single-circuit transmission line. In the case of the both side comparison type, like the equation (68), the operation thereof can be effected in exactly the same manner by changing $\Sigma I_B Z$ of the second embodiment to that obtained by taking the adjacent circuit current into consideration.

Up to the fourth embodiment, calculation of the fault point voltage is effected by use of the equation (4) or (66). However, the calculation of the fault point voltage is not limited to the equation (4) or (66) and the following equation (69) can be used.

$$V_F \;=\; |I_{FE}| Im[V_A \times \Sigma I_A Z^*] / Im[I_{FE} \times \Sigma I_A Z^*] \qquad (69)$$

The equation (69) is used to derive the magnitude of the fault point voltage $V_F$ by use of means similar to that of the equation (1). That is, in the equation (1), the quotient of line voltage $V_{LA}$ obtained by eliminating the fault point voltage $V_F$ having the same phase as $I_{FE}$ from the voltage $V_A$ of the numerator of the right side divided by the product $I_A Z$ is derived by use of the conjugate complex number $I_{FE}^*$. In the equation (69), the quotient of the fault point voltage $V_F$ obtained by eliminating the line voltage $V_{LA}$ having the same phase as the product $\Sigma I_A Z$ from the voltage $V_A$ of the numerator of the right side divided by the current $I_{FE}$ is derived by use of the conjugate complex number $\Sigma I_A Z^*$ and $|I_{FE}|$ is multiplied to derive the magnitude of the fault point voltage $V_F$.

The product $\Sigma IZ$ of the current and impedance is not limited to the above form but may take various other forms. The following equation (70) indicates one example of the form.

$$\Sigma IZ \;\text{---}\; I a Z_1 + K_0 I_0 Z_0 \qquad (70)$$

In the equation (70), Ia is a phase current, $K_0$ is a constant, $I_0$ is a zero phase current, and $Z_1$ and $Z_0$ are positive phase impedance and zero phase impedance of the unit length of the transmission line.

The equation (70) is an equation indicating the product $\Sigma IZ$ at the time of the a phase single-phase grounding fault and is the same as the equation used for the grounding distance relay for a phase fault protection. The product $\Sigma IZ$ is approximately equal to the voltage drop of a phase of the transmission line and the equation (70) can be used in the same manner as the equation (59).

20

The product $\Sigma IZ$ used in the equations for calculation of the hypothesis error, that is, the equations (5), (27), (28), (30), (31), (33) to (43), (53) includes not only those which are perfectly equal to $\Sigma IZ$ (or $\Sigma|IZ|$) as indicated by the equations (59), (62) and (70), but also those which are in approximately equal relation with $\Sigma IZ$ (or $\Sigma|IZ|$) as indicated by the following equations.

maximum value of$\{|\Sigma IZ|$ (or $\Sigma|IZ|$)$-K_1\}$ and 0      (71)

$\{|\Sigma IZ|$ (or $\Sigma|IZ|$)$+K_1\}$      (72)

In a case where $|\Sigma IZ|$ (or $\Sigma|IZ|$) is used in the denominator of the equation for calculating the hypothesis error, the equation (71) is used, and in a case where $|\Sigma IZ|$ (or $\Sigma|IZ|$) is used in the numerator of the equation for calculating the hypothesis error, the equation (72) is used.

In a case where it is assumed that the error of the current I is constructed by a proportional portion which varies in proportion to the magnitude of I and a fixed portion which has no relation with the magnitude of I as is ordinarily effected, the equations (71) and (72) are used when the magnitude of I is small and an influence by the fixed portion is large. In such a case, the error of $|\Sigma IZ|$ (or $\Sigma|IZ|$) can also be treated by a proportional portion which varies in approximate proportion to $|\Sigma IZ|$ (or $\Sigma|IZ|$) and a fixed portion which has no relation with $|\Sigma IZ|$ (or $\Sigma|IZ|$). The influence by the fixed portion is such that errors of the fixed portion and proportional portion may be added together to increase the error of $|\Sigma IZ|$ (or $\Sigma|IZ|$) in some cases and may cancel each other to reduce the error of $|\Sigma IZ|$ (or $\Sigma|IZ|$) in other cases. When the term of $|\Sigma IZ|$ (or $\Sigma|IZ|$) is used for the numerator of the equation for calculation of the hypothesis error, a case wherein the error is large is considered and the equation (72) is used. The influence by the fixed portion increases a value of $|\Sigma IZ|$ (or $\Sigma|IZ|$) in some cases and reduces the same in other cases. When $|\Sigma IZ|$ (or $\Sigma|IZ|$) is used for the denominator of the equation for calculation of the hypothesis error, a case wherein the error is large is considered and the equation (71) is used.

When the fault point voltage hypothesis error $Q_{VF}$ is calculated, it is not always necessary to set the numerator of the equation (5) to the fault point voltage $V_F$ itself and, for example, it can be calculated as indicated by the following equation (73).

$$Q_{VF} = K_{VF}(|V_F|+K^2)/\Sigma IZ \qquad (73)$$

In above equation, $K^2$ is used to consider a fixed error component when the fault point voltage $V_F$ is small.

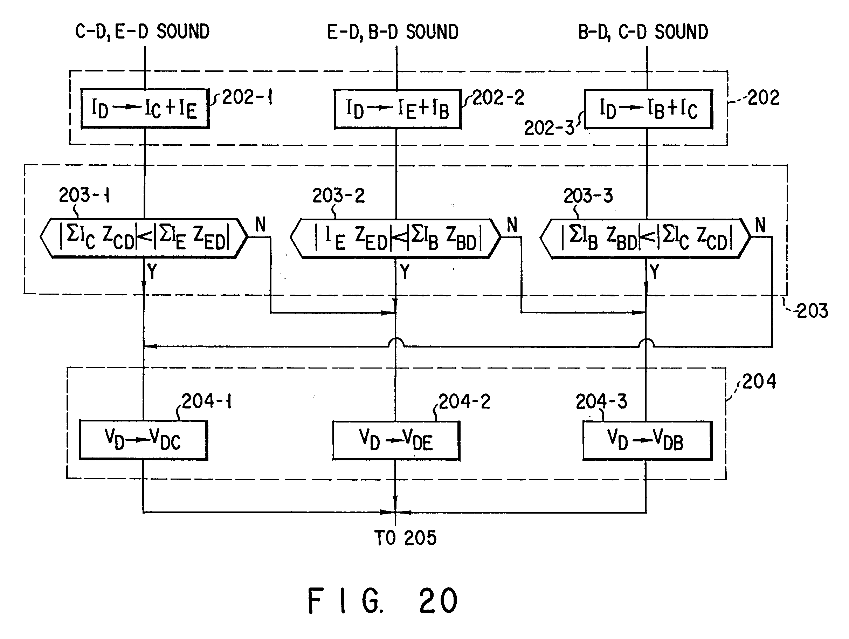

Another embodiment in which this invention is applied to the 3-terminal transmission line of Fig. 2 is explained with reference to the accompanying drawing. Fig. 20 is a diagram showing the detail of the processes 202 to 204 of Fig. 17.

The processes 201-1, 202-2, 203-3 are processes for calculating the current $I_D$ on the fault point side of the branch point and set the current $I_D$ to the respective added values shown in Fig. 20.

The processes 203-1, 203-2, 203-3 are processes for comparing the fault phase voltage drops in the sound sections of the transmission line and provide the processing result of "Y" when the condition indicated in the drawing is satisfied and provide the processing result of "N" when the condition is not satisfied.

The processes 204-1, 204-2, 204-3 are processes for calculating the branch point voltage $V_D$ and calculate voltages shown in the drawing and already calculated in the process 201.

If a C-D section and E-D section are determined to be sound in the process 201, the process 202-1 is effected and the current $I_D$ is set to a value ($I_C+I_E$). Then, the process 203-1 is effected, and if $|\Sigma I_C Z_{CD}|<|\Sigma I_E Z_{ED}|$, the processing result becomes "Y" and a voltage $V_{DC}$ of the equation (3b) which is already calculated in the process 201 is calculated in the process 204-1 and is set as a branch point voltage $V_D$. On the other hand, if $|\Sigma I_C Z_{CD}|\geqq|\Sigma I_E Z_{ED}|$, the processing result becomes "N" and a voltage $V_{DE}$ of the equation (3c) is set as a branch point voltage $V_D$ in the process 204-2. The operation effected when a different determination for the sound section is made in the process 201 becomes the same if the section is exchanged, and therefore, the explanation therefore is omitted.

In the above explanation, the branch point voltage $V_D$ is calculated by using a voltage at a point at which the magnitude of the fault phase voltage drop is minimum, but a voltage at a point at which the magnitude of the fault phase voltage drop is not minimum, but sufficiently small may be used. In this case, the processes 203-1, 203-2, 203-3 may be changed as follows.

Process 203-1 : $|\Sigma I_C Z_{CD}|<|\Sigma I_E Z_{ED}|+K_3$      (74a)

Process 203-2 : $|\Sigma I_E Z_{ED}| + K_3 < |\Sigma I_B Z_{BD}|$    (74b)

Process 203-3 : $|\Sigma I_B Z_{BD}| < |\Sigma I_C Z_{CD}| + K_3$    (74c)

where $K_3$ is a positive constant.

In the equation (74a), even when $|\Sigma I_C Z_{CD}|$ is larger than $|\Sigma I_E Z E_D|$, if the difference therebetween is smaller than a constant value $K_3$, the point C is treated as a point corresponding to the point at which the magnitude of the fault point voltage drop is minimum and a voltage $V_{DC}$ is calculated as the branch point voltage $V_D$ in preference to a voltage $V_{DE}$. Likewise, in the equations (74b) and (74c), if the difference is smaller than a constant value $K_3$, a voltage $V_{DB}$ is used in preference to $V_{DC}$ and $V_{DE}$.

In the other embodiment, only comparisons between $V_C$ and $V_E$, $V_E$ and $V_D$, $V_D$ and $V_C$ may be effected instead of the processes 203-1, 203-2, 203-3 of the above embodiment.

Another embodiment in which this invention is applied to the distance relay apparatus of 3-terminal transmission line shown in Fig. 2 is explained with reference to the accompanying drawing.

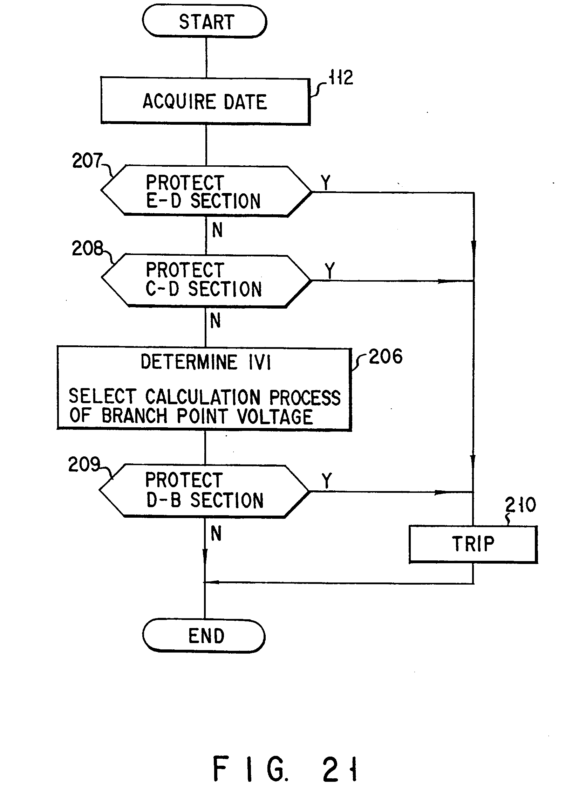

Fig. 21 is a flowchart for illustrating the operation of the distance relay apparatus effected when only data items from the terminals C and E are used for the protecting operation in a case where an abnormal condition occurs in the communication and data of the terminal B is not obtained. First, data is acquired in the process 112 and the protecting operation for a E-D section is effected in the process 207. The process is the same as the process of a normal distance relay apparatus using the voltage and current at the terminal E, and if a fault occurs at a point lying in a range from the terminal E to a point slightly exceeding the branch point D, the operation is effected to command interruption between the terminals C and E in the process 201. When the above command is not generated, the protecting operation for the C-D section is effected in the process 208. The process is similar to the process 207 except that the voltage and current at the terminal C are used, and if a fault occurs at a point lying in a range from the terminal C to a point slightly exceeding the branch point D, the operation is effected to command interruption between the terminals C and E in the process 201. When the above command is not generated, the voltages at the terminals C and E are compared with each other in the process 206 and one of the equations (3b) and (3c) used for calculation of the voltage $V_D$ at the branch point D is selected. Then, the protecting operation for the D-B section, that is, the protecting operation for a section as viewed from the branch point D towards the terminals B is effected by using the voltage $V_D$ selected in the process 209 and the sum $(I_C + I_E)$ of currents at the terminals C and E. If the above protecting operation is effected, a command for interruption between the terminals C and E is generated in the process 201. If the above protecting operation is not effected, a command for interruption is not generated and a sequence of processes is completed. In the above processing operation, since the protection for the D-B section in the process 209 is effected by indirectly acquiring data at the branch point D, the performance thereof can be can be significantly enhanced in comparison with the conventional distance relay apparatus which effects the protection by using only the voltage and current at each of the terminals C and E. Since the process 206 provides data of a branch point voltage with high precision, the performance of the protecting operation is further enhanced. It is possible to use the process 203 instead of the process 206.

**Claims**

1.  A fault locator including fault point determining means for receiving a voltage and current of at least one point of a transmission line and calculating a distance XL from a specified point on the transmission line to a fault point which is at least one of short-circuiting and grounding faults occurring on the transmission line according to the relation between a fault phase voltage V in a fault section of said transmission line and the product $\Sigma IZ$ of a current I and an impedance Z expressing a voltage drop for the fault phase voltage V, characterized by comprising:

    first means for calculating the value of a voltage $V_F$ of the fault point by use of the fault phase voltage V, the product $\Sigma IZ$ and the distance XL;

    second means for calculating a value of the product $\Sigma IZ$ of a preset current I flowing in said fault section of said transmission line and the impedance Z; and

    third means for calculating a value $Q_{VF} \propto V_F/\Sigma IZ$ which varies in proportion to the quotient of the value obtained by said first means divided by the value obtained by said second means as a fault point voltage hypothesis error $Q_{VF}$.

2. A fault locator according to claim 1, characterized in that said fault point determining means is formed of single side determination type for measuring a distance by use of a voltage drop between a fault point F and a specified point A lying on one of two sides of the fault point on said fault section of said transmission line, and the preset current I is given by a current $I_A$ flowing in a direction from the specified point A side to the fault point.

3. A fault locator according to claim 1, characterized in that said fault point determining means is formed of both side comparison type for measuring a distance by use of a voltage difference between specified points A and B lying on both sides of the fault point on said fault section of said transmission line, and the preset current I is given by a current $(I_A + I_B)$ which is the sum of currents $I_A$ and $I_B$ flowing from both of said specified points A and B towards the fault point.

4. A fault locator including both side comparison type fault point determining means for receiving voltages and currents of a plurality of points of a transmission line and calculating a distance XL from a specified point A to a fault point which is at least one of short-circuiting and grounding faults occurring on said transmission line according to the relation between a difference in a fault phase voltage V between said specified points A and B lying on both sides of the fault point in said fault section of said transmission line and the product $\Sigma IZ$ of a current I and an impedance Z expressing a voltage drop for the fault phase voltage V, characterized by comprising:

means for calculating a first term which is a function of the quotient of at least one of the term of the product $\Sigma I_A Z$ using the calculated value XL of the distance from said point A and a current $I_A$ flowing from said point A towards the fault point and the term of the sum $\Sigma |I_A Z|$ of the magnitudes of respective terms constructing the $\Sigma I_A Z$ divided by the term of the product $\Sigma (I_A + I_B) Z$ using the sum of the currents $I_A$ and $I_B$;

means for calculating a second term which is a function of the quotient of at least one of the term of the product $\Sigma I_B Z$ using the calculated value (1-X)L of the distance from said point B and a current $I_B$ flowing from said point B towards the fault point and the term of the sum $\Sigma |I_B Z|$ of the magnitudes of respective terms constructing the $\Sigma I_B Z$ divided by the term of the product $\Sigma (I_A + I_B) Z$; and

means for calculating a distance proportional error $Q_{XL}$ by using the sum of the first and second terms and one of the first and second terms.

5. A fault locator according to claim 4, characterized in that the distance proportional error $Q_{XL}$ is given by the quotient of the sum of the magnitude of a value obtained by multiplying the product $XL\Sigma I_A Z$ by a preset constant $K_A$ and the magnitude of a value obtained by multiplying the product $(1-X)L\Sigma I_B Z$ by a preset constant $K_B$ divided by the magnitude of a value of the product $\Sigma (I_A + I_B) Z$, that is,

$$Q_{XL} = \{|K_A XL\Sigma I_A Z| + |K_B (1-X)L\Sigma I_B Z|\} / |\Sigma (I_A + I_B) Z|.$$

6. A fault locator according to claim 4, characterized in that the distance proportional error $Q_{XL}$ is given by the following equation:

$$Q_{XL} = \{|K_A' XL\Sigma I_A Z - K_B'(1-X)L\Sigma I_B Z| + |K_A XL\Sigma I_A Z| + |K_B (1-X)L\Sigma I_B Z|\} / |\Sigma (I_A + I_B) Z|.$$

7. A fault locator according to claim 4, characterized in that the distance proportional error $Q_{XL}$ is given by the following equation:

$$Q_{XL} = \{|K_A XL\Sigma |I_A Z| - K_B (1-X)L\Sigma |I_B Z| |\} / |\Sigma (I_A + I_B) Z|.$$

8. A fault locator according to claim 4, characterized in that the distance proportional error $Q_{XL}$ is given by the following equation:

$$Q_{XL} = \{|K_A' XL\Sigma I_A Z - K_B'(1-X)L\Sigma I_B Z| + K_A XL\Sigma |I_A Z| + |K_B (1-X)L\Sigma |I_B Z| |\} / |\Sigma (I_A + I_B) Z|.$$

9. A fault locator according to claim 4, characterized in that the distance proportional error $Q_{XL}$ is given by the following equation:

$$Q_{XL} = [(K_A XL\Sigma I_A Z)^2 + \{K_B (1-X)L\Sigma I_B Z\}^2]^{1/2} / |\Sigma (I_A + I_B) Z|.$$

10. A fault locator according to claim 4, characterized in that the distance proportional error $Q_{XL}$ is given by $Q_{XLA}$ and $Q_{XLB}$ expressed by the following equations:

$$Q_{XLA} = |K_A X L \Sigma I_A Z / \Sigma (I_A + I_B) Z|, \text{ and}$$
$$Q_{XLB} = |K_B (1-X) L \Sigma I_B Z / \Sigma (I_A + I_B) Z|.$$

11. A fault locator including fault point determination means which includes distance measuring means for receiving a voltage and current of at least one point of a transmission line and calculating a distance XL from a specified point on a fault section of said transmission line to a fault point which is at least one of short-circuiting and grounding faults occurring on said transmission line according to the relation between a fault phase voltage V in said fault section of said transmission line and the product $\Sigma IZ$ of a current I and an impedance Z expressing a voltage drop for the fault phase voltage V and specified-point-voltage calculating means for calculating a value of a voltage $V_D$ of a specified point D lying on the sound section of said transmission line near the fault point by use of a voltage VC of another specified point C lying on said sound section at a far distance from the fault point and the product $\Sigma I_C Z_{CD}$ of a current $I_C$ flowing from said point C towards said point D and an impedance $Z_{CD}$ between said points C and D, characterized by comprising:

first means for calculating a value of one of the product $\Sigma I_C Z_{CD}$ and the sum $\Sigma |I_C Z_{CD}|$ of the magnitudes of respective terms of the product;

second means for calculating a value of the product $\Sigma IZ$ of a preset current I flowing in said fault section of said transmission line and the impedance Z; and

third means for calculating one of values $Q_{CD} \propto I_C Z_{CD} / \Sigma IZ$ and $Q_{CD} \propto \Sigma |I_C Z_{CD}| / \Sigma IZ$ which varies in proportion to the quotient of one of the product $\Sigma I_C Z_{CD}$ and the sum $\Sigma |I_C Z_{CD}|$ obtained by said first means divided by the product $\Sigma IZ$ obtained by said second means as a sound section hypothesis error $Q_{VF}$.

12. A fault locator according to claim 11, characterized in that said distance measuring means is formed of single side determination type for measuring a distance XL from a point A lying on one of two sides of the fault point on said fault section of said transmission line by use of a voltage drop between a fault point F and said specified point A, and the preset current I is given by a current $I_A$ flowing in a direction from said specified point A side to the fault point.

13. A fault locator according to claim 12, characterized in that said distance measuring means includes means for calculating a distance XL from said specified point A when said point A coincides with said point D.

14. A fault locator according to claim 4, characterized in that said distance measuring means is formed of both side comparison type for measuring a distance XL from specified points A and B lying on both sides of the fault point on said fault section of said transmission line by use of a voltage difference between said specified points A and B, and the preset current I is given by a current $(I_A + I_B)$ which is the sum of currents $I_A$ and $I_B$ flowing from both of said specified points A and B towards the fault point.

15. A fault locator according to claim 14, characterized in that said distance measuring means includes means for calculating a distance XL from said specified points A and B when one of said points A and B coincides with said point D.

16. A fault locator according to claim 11, characterized in that said self-point determination means is formed of single side determination type for measuring a distance by use of a voltage drop between a fault point F and a specified point A lying on one of two sides of the fault point on said fault section of said transmission line, the preset current I is given by a current $I_A$ flowing in a direction from said specified point A side to the fault point, and a value of $Q_{XL}$ is calculated as a value which is proportional to a calculated value XL of the distance between said specified point A and the fault point.

17. A fault locator according to claim 11, characterized in that the value of $Q_{XL}$ is given by a value $K_A Q_{XL}$ obtained by multiplying a calculated value XL of distance between said specified point A and the fault point by a specified constant $K_A$.

24

**18.** A fault locator according to claim 11, characterized in that the value of $Q_{XL}$ is given by a value $XL\{K_A'' + (K_A\Sigma|IZ|/|\Sigma IZ|)\}$ which is obtained by multiplying a calculated value XL of distance between said specified point A and the fault point by a value derived by the sum of a specified constant $K_A''$ and the quotient of the product of a specified constant $K_A$ and the sum $\Sigma|IZ|$ of the magnitudes of respective terms of the product $\Sigma IZ$ divided by the magnitude of the product $\Sigma IZ$.

**19.** A fault locator according to claim 11, characterized in that said fault point determination means is formed of both side comparison type for measuring a distance by use of a voltage difference between specified points A and B lying on both sides of the fault point on said fault section of said transmission line, the preset current I is given by a current $(I_A + I_B)$ which is the sum of currents $I_A$ and $I_B$ flowing from both of said specified points towards the fault point, and the value of $Q_{XL}$ is given by the sum of one of the term of the product $\Sigma I_A Z$ using a calculated value XL of distance from said point A and a current $I_A$ on said point A side and the term of the sum $\Sigma|I_A Z|$ of the magnitudes of respective terms constituting $\Sigma I_A Z$ and one of the term of the product $\Sigma I_B Z$ using a calculated value (1-X)L of distance from said point B and a current $I_B$ on said point B side and the term of the sum $\Sigma|I_B Z|$ of the magnitudes of respective terms constituting $\Sigma I_B Z$.

**20.** A fault locator including fault point determination means for receiving a voltage and current of at least one point of a transmission line and calculating a distance XL from a specified point on a fault section of said transmission line to a fault point which is at least one of short-circuiting and grounding faults occurring on said transmission line according to the relation between a fault phase voltage V in said fault section of said transmission line and the product $\Sigma IZ$ of a current I and an impedance Z expressing a voltage drop for the fault phase voltage V, characterized by comprising:

first means for calculating a value of fault point voltage $V_F$;

second means for calculating a value of the product $\Sigma IZ$ of a preset current I flowing in said fault section of said transmission line and the impedance Z;

third means for calculating a value $Q_{VF} \propto V_F/\Sigma IZ$ which varies in proportion to the quotient of the value obtained by said first means divided by the value obtained by said second means as a fault point voltage hypothesis error $Q_{VF}$;

fourth means for calculating a value $Q_{XL}$ having a functional relation with the distance XL as a distance proportional error $Q_{XL}$; and

fifth means for outputting one of a first value derived by combining the value $Q_{VF}$ calculated by said third means and the value $Q_{XL}$ calculated by said fourth means and a second value calculated by using a value derived by adding the functions of the two values.

**21.** A fault locator including fault point determination means which includes distance measuring means for receiving a voltage and current of at least one point of a transmission line and calculating a distance XL from a specified point on a fault section of said transmission line to a fault point which is at least one of short-circuiting and grounding faults occurring on said transmission line according to the relation between a fault phase voltage V in said fault section of said transmission line and the product $\Sigma IZ$ of a current I and an impedance Z expressing a voltage drop for the fault phase voltage V and specified-point-voltage calculating means for calculating a value of a voltage $V_D$ of a specified point D lying on the sound section of said transmission line near the fault point by use of a voltage $V_C$ of another specified point C lying on said sound section at a far distance from the fault point and the product $\Sigma I_C Z_{CD}$ of a current $I_C$ flowing from said point C towards said point D and an impedance $Z_{CD}$ between said points C and D, characterized by comprising:

first means for calculating a value of fault point voltage $V_F$;

second means for calculating a value of the product $\Sigma IZ$ of a preset current I flowing in said fault section of said transmission line and the impedance Z;

third means for calculating a value $Q_{VF} \propto V_F/\Sigma IZ$ which varies in proportion to the quotient of the value obtained by said first means divided by the value obtained by said second means as a fault point voltage hypothesis error $Q_{VF}$;

fourth means for calculating a value $Q_{XL}$ having a functional relation with the distance XL calculated by said distance measuring means as a distance proportional error $Q_{XL}$;

fifth means for calculating one of values $Q_{CD} \propto I_C Z_{CD}/\Sigma IZ$ and $Q_{CD} \propto \Sigma|I_C Z_{CD}|/\Sigma IZ$ which varies in proportion to the quotient of one of the product $\Sigma I_C Z_{CD}$ calculated by said specified-point-voltage calculating means and the sum $\Sigma|I_C Z_{CD}|$ of the magnitudes of respective terms thereof divided by the product $\Sigma IZ$ obtained by said second means as a sound section hypothesis error $Q_{CD}$; and

sixth means for outputting one of a first value derived by combining the value $Q_{VF}$ calculated by said third means, the value $Q_{XL}$ calculated by said fourth means and the value $Q_{CD}$ calculated by said first means and a second value calculated by using a value derived by adding the functions of the three values.

**22.** A fault locator characterized by comprising:

distance measuring means for receiving voltages and currents of a plurality of points of a multiple terminal transmission line and calculating a distance XL from a specified point on a fault section of said transmission line to a fault point which is at least one of short-circuiting and grounding faults occurring on said transmission line according to the relation between a fault phase voltage V in said fault section of said transmission line and the product $\Sigma IZ$ of a current I and an impedance Z expressing a voltage drop for the fault phase voltage V; and

branch-point-voltage calculating means for calculating a value of a voltage of a branch point between a sound section and said fault section of said transmission line by subtracting a voltage drop of said sound section of said transmission line from one of voltages V1 to Vn of a plurality of points P1 to Pn which are selected from said plurality of points and have no fault point between themselves and said branch point by use of the voltages V1 to Vn, currents I1 to In and the impedance of said transmission line in said sound section;

wherein said branch-point-voltage calculating means includes means for calculating a value of the voltage of said branch point by using a voltage of one of a point which is selected from said points P1 to Pn so that the fault phase voltage drop in said sound section of said transmission line between itself and said branch point becomes minimum and a corresponding point and a voltage drop of said transmission line between said point and said branch point.

**23.** A fault locator according to claim 22, characterized in that said branch-point-voltage calculating means includes means for calculating a branch point voltage $V_D$ according to an operation procedure using a smaller value of the magnitudes of the fault phase voltage drops $\Sigma IZ$ in said sound section.

**24.** A fault locator characterized by comprising:

distance measuring means for receiving voltages and currents of a plurality of points of a multiple terminal transmission line and calculating a distance XL from a specified point on a fault section of said transmission line to a fault point which is at least one of short-circuiting and grounding faults occurring on said transmission line according to the relation between a fault phase voltage V in said fault section of said transmission line and the product $\Sigma IZ$ of a current I and an impedance Z expressing a voltage drop for the fault phase voltage V; and

branch-point-voltage calculating means for calculating a value of a voltage of a branch point between a sound section and said fault section of said transmission line by subtracting a voltage drop of said sound section of said transmission line from one of voltages V1 to Vn of a plurality of points P1 to Pn which are selected from said plurality of points and have no fault point between themselves and said branch point by use of the voltages V1 to Vn, currents I1 to In and the impedance of said transmission line in said sound section;

wherein said branch-point-voltage calculating means includes means for calculating a value of the voltage of said branch point by using a voltage of one of a point of said points P1 to Pn at which the fault phase voltage is minimum and a corresponding point and a voltage drop of said transmission line between said point and said branch point.

**25.** A fault locator according to claim 24, characterized in that said branch-point-voltage calculating means includes means for calculating a branch point voltage $V_D$ according to an operation procedure for comparing the magnitudes of voltages of the respective terminals of said sound section and using the lowest voltage.

F I G. 1 (PRIOR ART)

F I G. 2

F I G. 3

$X_{LA} = XLI_AZ$

$V_A$

$\theta_Z$

$0$    $I_A$

$V_F$

F I G. 4

$m$   $V_{Fm}$

$V_{LAm}$   $V$

$V_A$

$\theta_Z$

$0$    $I_A$

$I_{FE}$

F I G. 5

$m'$   $\theta_{VF}$   $V'$

$n'$

$0$

F I G. 6

START

$f_A$ AND/OR $f'_A$    ~104

$f_B$ AND/OR $f'_B$    ~105

CALCULATE $Q_{XL}$    ~106

END

F I G. 7

AREA IN WHICH $1+\varepsilon_{EA}$ CAN EXIST

$1$

$0$

AREA IN WHICH $\varepsilon_{EA}$ CAN EXIST

F I G.  8

$0$

AREA IN WHICH $1+\varepsilon_{EA}$ CAN EXIST

$1+K'_{EA}$

AREA IN WHICH $\varepsilon_{EA}$ CAN EXIST
(RADIUS $K_{EA}$)

F I G.  9

$\Sigma IbZab$

$\Sigma Ia Zaa$

$0$

$\Sigma IcZac$

$\Sigma IZ$

F I G.  10

$V(IbZab)$

$0$

$V(IcZac)$

$V(Ia Zaa)$

F I G.  11

$C$   $I_C$

$DA$   $I_A$

$F$   $I_B$   $B$

$V_C$   $Z_{CD}$   $V_D$   $V_A$

$V_B$

F I G.  12

START

CALCULATE
$\Sigma I_C Z_{CD}$ ~107

CALCULATE
$\Sigma IZ$ ~102

CALCULATE
$Q_{CD} \ \Sigma I_C Z_{CD}/\Sigma IZ$ ~108

END

F I G. 13

START

CALCULATE $V_F$ ~101

CALCULATE $\Sigma IZ$ ~102

CALCULATE $Q_{VF}$ ~103

CALCULATE $Q_{XL}$ ~109

OUTPUT RESULTS ~110

END

F I G. 14

START

CALCULATE $V_F$ ~101

CALCULATE $\Sigma IZ$ ~102

CALCULATE $Q_{VF}$ ~103

CALCULATE $Q_{XL}$ ~109

CALCULATE $\Sigma I_C Z_{CD}$ ~107

CALCULATE $Q_{CD} \ \Sigma I_C Z_{CD}/\Sigma IZ$ ~108

OUTPUT RESULTS ~110

AND

F I G. 15

START

ACQUINE DATA ~112

DETERMINE AN ACCIDENT POINT 1 ~113

HYPOTHESIGE AN ERROR 1 ~114

DETERMINE AN ACCIDENT POINT 2 ~115

HYPOTHESIGE AN ERROR 2 ~116

DETERMINE AN ACCIDENT POINT 3 ~117

HYPOTHESIGE AN ERROR 3 ~118

EDIT RESULTS ~119

END

F I G. 16

**START**

DETERMINE SOUND SECTION ~201

CALCULATE BRANCH POINT CURRENT ~202

DETERMINE $|\Sigma IZ|$

SELECT CALCULATION PROCESS OF BRANCH POINT VOLTAGE ~203

CALCULATE BRANCH POINT VOLTAGE ~204

DETERMINE ACCIDENT POINT ~205

**END**

F I G. 17

**START**

DETERMINE SOUND SECTION ~201

CALCULATE BRANCH POINT CURRENT ~202

DETERMINE $|V|$

SELECT COLCULATION PROCESS OF BRANCH POINT VOLTAGE ~206

CALCULATE BRANCH POINT VOLTAGE ~204

DETERMINE ACCIDENT POINT ~205

**END**

F I G. 18

**START**

ACQUIRE DATA ~112

DETERMINE AN ACCIDENT POINT ~113

CALCULATE $V_F$ ~101

CALCULATE $\Sigma IZ$ ~102

CALCULATE $Q_{VF}$ ~103

OUTPUT RESULTS ~120

**END**

F I G. 19

C-D, E-D SOUND          E-D, B-D SOUND          B-D, C-D SOUND

$$I_D \rightarrow I_C + I_E \quad 202\text{-}1$$

$$I_D \rightarrow I_E + I_B \quad 202\text{-}2$$

$$I_D \rightarrow I_B + I_C \quad 202$$

$$202\text{-}3$$

203-1          203-2          203-3

$$\langle |\Sigma I_C \ Z_{CD}| < |\Sigma I_E \ Z_{ED}| \rangle \ N$$

$$\langle |I_E \ Z_{ED}| < |\Sigma I_B \ Z_{BD}| \rangle \ N$$

$$\langle |\Sigma I_B \ Z_{BD}| < |\Sigma I_C \ Z_{CD}| \rangle \ N$$

Y          Y          Y

203

204

204-1          204-2          204-3

$$V_D \rightarrow V_{DC}$$

$$V_D \rightarrow V_{DE}$$

$$V_D \rightarrow V_{DB}$$

TO 205

F I G.  20

EP 0 578 123 A2

F I G. 2 1